# EUROPEAN PATENT APPLICATION

(11) **EP 3 091 279 A1**
(43) Date of publication of application: **09.11.2016**
(21) Application number: 14858992.2
(22) Date of filing: 25.06.2014
(51) Int. Cl.: F21Y 101/00, F21V 29/00

(54) **LED LIGHT SOURCE HEAT DISSIPATION STRUCTURE AND HEAT DISSIPATION METHOD THEREOF**

(30) Priority: 29.10.2013 CN 201310518651; 08.05.2014 CN 201410192030
(71) Applicant: Cai, Hong, Shantou, Guangdong 515000 (CN)
(72) Inventor: CAI, Zhou, Shantou Guangdong 515000 (CN)
(74) Representative: Casalonga
(86) International application number: PCT/CN2014/080674
(87) International publication number: WO 2015/062293

(57) **Abstract**

An LED lamp heat dissipation structure and heat dissipation method thereof, the structure comprising at least one LED light emitting body (10) and at least one heat dissipating conductor (20), the heat dissipating conductor being made of an exposed structure having a large heat dissipation surface; the positive and negative level conductors of the LED light emitting body are connected between the LED light emitting body and the electrode connection thermally conductive heat dissipating part; the electrode connection heat conducting-dissipating portion (30) is used for delivering to the LED light emitting body by means of the positive and negative level conductors the current in the signal power transmission heat-dissipation portion (40) and the electrical signal; at the same time, the heat generated when the LED light emitting body energizes and emits light is conducted to the electrode connection heat conducting-dissipating portion, and the electrode connection heat conducting-dissipating portion radiates the heat outward; simultaneously, the electrode connection heat conducting-dissipating portion can further conduct heat to the signal power transmission heat-dissipation portion, and the signal power transmission heat-dissipation portion radiates the heat outward.

## Description

### FIELD OF INVENTION

The present invention relates to a heat dissipation structure and heat dissipation method thereof, and more particularly to a heat dissipation structure and heat dissipation method thereof for cooperating with an LED light source.

### DESCRIPTION OF RELATED ARTS

In order to effectively operate the conventional LED light sources, effective heat-dissipation structures are required. Typically, a heat-dissipation mechanism or device comprises a cooling fan means for generating a thermal natural convection and is disposed with a heat pipe and a heat absorber structure and so on. The cooling fan means has a simple structure and a low reliability, the heat pipe has a relatively low heat dissipation rate, and the heat-dissipation mechanism is limited by the surface area of the heat sinks thereof. All of these existing structures cannot satisfactorily solve the heat problem.

PCT. Pat. No. CN2011/000756 discloses an LED light source and manufacturing method thereof, which describes an LED element glowing through both sides thereof so as to avoid heat accumulation in the combining surface and the substrate of the conventional LED light source, and the LED element is directly sandwiched between two fluorescent elements to define one or more channels so as to achieve heat transfer of the LED element through a guide of these channels.

Its structure includes one or more LED light sources, wherein each of the LED light sources includes: at least one LED element and two fluorescent elements, wherein the LED light element has a first emitting surface and an opposite second emitting surface, wherein the LED light element is adapted for providing an illumination having a more than 180° angle on each of the first emitting surface and the second emitting surface by electroluminescent lighting, wherein the fluorescent elements are respectively provided on the upper portions of the first emitting surface and the second emitting surface of the LED element to hold the LED element at a position so as to make the illumination generated from the LED light source emit from the first emitting surface and the second emitting surface and pass through the two fluorescent elements and an electronic element, wherein the electronic element is coupled with the LED element to connect the LED element with a power source.

The LED element is sandwiched between the two fluorescent elements to hold the LED element at a position so as to press the first emitting surface and the second emitting surface against on the two fluorescent elements such that the first emitting surface and the second emitting surface is supported and heat is guided to leave away from the LED element, and the LED element is held in a LED receiving chamber provided in a gap between the two fluorescent elements.

The above-mentioned technology can be applied to a specific product to enable the product to have a smaller size and achieve an excellent emitting effect, which can simultaneously emit light in various directions by utilizing a single LED light source. However, when the LED light source is specifically implemented, because it can merely dissipate heat by the first emitting surface and the second emitting surface although the above-mentioned technology has a good idea, when the LED light source is specifically implemented, it has an unsatisfactory effect and a low heat- dissipation that the LED element is overheated. In a worse case, the whole LED light source may be burn down. Above stated are main disadvantages of the conventional art.

### SUMMARY OF THE PRESENT INVENTION

The present invention provides an LED light source heat-dissipation structure and a heat-dissipation method thereof, wherein the heat dissipating conductor made of an exposed structure having a large heat-dissipation surface, which can significantly improve the heat-dissipation effect thereof. That is, the above is a main object of the present invention.

The present invention employs the following technical solution: an LED light source heat-dissipation structure, which comprises at least one LED light emitting body and at least one heat dissipating conductor, wherein the LED light emitting body comprises a P-type semiconductor and a N-type semiconductor, wherein the P-type semiconductor and the N-type semiconductor define a PN junction, wherein the voltage is applied to two ends of the PN junction to make the PN junction form an energy level by itself so as to enable electrons to move up from the energy level and produce photons and illuminate.

The heat dissipating conductor is made of the exposed structure having a large heat-dissipation surface, wherein the heat dissipating conductor comprises an electrode connection heat conducting and dissipating portion and a signal power transmission heat-dissipation portion, wherein the electrode connection heat conducting-dissipating portion is connected with the signal power transmission heat-dissipation portion to define the heat dissipating conductor, wherein each of the electrode connection heat conducting-dissipating portion and the signal power transmission heat-dissipation portion is respectively made of an exposed structure having a large heat-dissipation surface.

The positive and negative conductors of the LED light emitting body are connected between the LED light emitting body and the electrode connection heat conducting-dissipating portion, wherein the electrode connection heat conducting-dissipating portion is used for transferring the electric current and the control signals from the signal power transmission heat-dissipation portion to the LED light emitting body by the positive and negative conductors. At the same time, the heat generated when the LED light emitting body energizes and emits is conducted to the electrode connection heat conducting-dissipating portion by the positive and negative conductors and dissipated by the electrode connection heat conducting-dissipating portion. Simultaneously, the electrode connection heat conducting-dissipating portion can transfer the heat to the signal power transmission heat-dissipation portion and the heat is outwardly dissipated by the signal power transmission heat-dissipation portion.

A heat-dissipation method for an LED light source, which comprises the steps of: providing the heat dissipating conductor around the LED light emitting body, wherein the LED light emitting body comprises a P-type semiconductor and a N-type semiconductor, wherein the P-type semiconductor and the N-type semiconductor define a PN junction, wherein the heat dissipating conductor is made of an exposed structure having a large heat-dissipation surface, wherein the heat dissipating conductor comprises an electrode connection heat conducting and dissipating portion and a signal power transmission heat-dissipation portion, wherein the electrode connection heat conducting-dissipating portion is connected with the signal power transmission heat-dissipation portion to define the heat dissipating conductor, wherein each of the electrode connection heat conducting-dissipating portion and the signal power transmission heat-dissipation portion is respectively made of an exposed structure having a large heat-dissipation surface, wherein the heat dissipation and conduction effect of the electrode connection heat conducting and dissipating portion and the signal power transmission heat-dissipation portion can be greatly improved by the exposed structure having a large heat-dissipation surface; and connecting the positive and negative conductors of the LED light emitting body between the LED light emitting body and the electrode connection heat conducting-dissipating portion, wherein the electrode connection heat conducting-dissipating portion is used for transferring the electric current and the control signals from the signal power transmission heat-dissipation portion to the LED light emitting body. At the same time, the heat generated when the LED light emitting body energizes and emits is conducted to the electrode connection heat conducting-dissipating portion by the positive and negative conductors and dissipated by the electrode connection heat conducting-dissipating portion. Simultaneously, the electrode connection heat conducting-dissipating portion can transfer the heat to the signal power transmission heat-dissipation portion and the heat is outwardly dissipated by the signal power transmission heat-dissipation portion.

A heat-dissipation structure for an LED light source, which comprises at least one LED light emitting body and at least one heat dissipating conductor, wherein the LED light emitting body comprises an upper light emitting surface and a lower light emitting surface, wherein the heat dissipating conductor is made of an exposed structure having a large heat-dissipation surface, wherein the heat dissipating conductor comprises a conducting and transferring portion for holding the LED light emitting body and a signal power transmission heat-dissipation portion, wherein the conducting and transferring portion for holding the LED light emitting body is fixed at the signal power transmission heat-dissipation portion.

The LED light emitting body is held at the conducting and transferring portion, wherein the conducting and transferring portion for holding the LED light emitting body fixes the LED light emitting body at a position, which simultaneously enhances the heat transmission contact surface between the heat dissipating conductor and the LED light emitting body. In addition, the conducting and transferring portion for holding the LED light emitting body can also transfer the electric current and the control signals from the signal power transmission heat-dissipation portion to the LED light emitting body.

The heat generated when the LED light emitting body energizes and emits is directly conducted to the conducting and transferring portion for holding the LED light emitting body and dissipated by the conducting and transferring portion for holding the LED light emitting body. Simultaneously, the conducting and transferring portion for holding the LED light emitting body can transfer the heat to the signal power transmission heat-dissipation portion and the heat is outwardly dissipated by the signal power transmission heat-dissipation portion.

An LED light source heat-dissipation structure, which comprises at least one LED light emitting body and at least one heat dissipating conductor, wherein the LED light emitting body comprises an upper light emitting surface and a lower light emitting surface, wherein the heat dissipating conductor is made of an exposed structure having a large heat-dissipation surface, wherein the heat dissipating conductor comprises wherein the heat dissipating conductor comprises an electrode connection heat conducting and dissipating portion and a signal power transmission heat-dissipation portion, wherein the electrode connection heat conducting-dissipating portion is connected with the signal power transmission heat-dissipation portion to define the heat dissipating conductor, wherein the positive and negative conductors of the LED light emitting body are connected between the LED light emitting body and the electrode connection heat conducting-dissipating portion, wherein the electrode connection heat conducting-dissipating portion is used for transferring the electric current and the control signals from the signal power transmission heat-dissipation portion to the LED light emitting body by the positive and negative conductors. At the same time, the heat generated when the LED light emitting body energizes and emits is conducted to the electrode connection heat conducting-dissipating portion by the positive and negative conductors and dissipated by the electrode connection heat conducting-dissipating portion. Simultaneously, the electrode connection heat conducting-dissipating portion can transfer the heat to the signal power transmission heat-dissipation portion and the heat is outwardly dissipated by the signal power transmission heat-dissipation portion, wherein the signal power transmission heat-dissipation portion comprises a plurality of signal power transmission heat dissipating conductors.

The LED light emitting body and the heat dissipating conductor are connected with each other to define an LED light-emitting and heat-dissipating body, wherein a sealing and transparent shade having an inner surface is provided and the inner surface of the sealing and transparent shade define a sealing cavity inner sealing cavity and a plurality of the LED light-emitting and heat-dissipating bodies are arranged within the sealing cavity inner sealing cavity, wherein the sealing cavity inner sealing cavity is filled with dissipating gas, wherein an airflow average-temperature equipment is disposed within the sealing cavity inner sealing cavity, and when the LED light emitting body is under working condition, it is energized to emit light and the heat generated by the LED light emitting body is dissipated into the dissipating gas by the heat dissipating conductor, and at the same time, the airflow average-temperature equipment drives the dissipating gas to circulate within the sealing cavity inner sealing cavity so as to make the dissipating gas at the different positions of the sealing cavity inner sealing cavity have a consistent temperature that the dissipating gas can outwardly dissipate the heat by the sealing and transparent shade lastly. The advantages of the present invention are as follows: the main function of the conventional conductor connected with the LED light emitting body is limited to providing power connection, and transferring the power control signals. Being limited by the functions of the conductor, the conventional conductor connected with the LED light emitting body is always packaged in the corresponding circuit board. The dissipation function of the conductor is ignored by the designers, so when a circuit layout for a conventional LED light emitting body is specifically designed, any relevant structure for improving the dissipation function of the conductor isn't considered. In contrast, the circuit layout of the conventional LED light emitting body even further limits the dissipation function of the conductor that the conductor merely plays a very small role in heat-dissipation in practical applications and the heat-dissipation function of the conductor is almost given up. Whereas the inventor of the present invention hammers away at the heat-dissipation problem of the LED light emitting body and an improved conductor structure can greatly enhance the heat-dissipation effect thereof. The outer wall of the conventional conductor connected with the LED light emitting body is always coated with an insulating layer that the heat-dissipation effect is impacted and ignored, so the whole surface area of the conventional conductor is possibly minimized, which is just the opposite of the idea of the present invention.

### BRIEF DESCRIPTION OF THE DRAWINGS

FIG.1 is a location diagram of at least one LED light emitting body and a conductor of the present invention.
FIG.2 is a location diagram of an electrode connection heat conducting and dissipating portion and a signal power transmission heat-dissipation portion of the present invention.
FIG.3 is a location diagram of a light-heat transmitting crystal layer of the present invention.
FIG.4 is a schematic diagram of a structure having multiple LED light emitting bodies of the present invention.
FIG.5 is a location diagram of a fixed heat-dissipation plate of the present invention.
FIG.6 is a schematic diagram of a layer structure comprising the above fixed heat-dissipation plate of the present invention.
FIG.7 is a top viewed structural diagram of a first embodiment of a second technical solution of the present invention.
FIG.8 is a location diagram of at least one LED light emitting body of the first embodiment of the second technical solution of the present invention.
FIG.9 is a side viewed structural diagram of the first embodiment of the second technical solution of the present invention.
FIG.10 is a perspective structural diagram of the first embodiment of the second technical solution of the present invention.
FIG.11 is a top viewed structural diagram of a second embodiment of the second technical solution of the present invention.
FIG. 12 is a cross-sectional diagram of the second embodiment of the second technical solution of the present invention.
FIG. 13 is a cross-sectional diagram of a third embodiment of the second technical solution of the present invention.
FIG. 14 is a cross-sectional diagram of a forth embodiment of the second technical solution of the present invention.
FIG. 15 is a location diagram of at least one LED light emitting body and a conductor of a third technical solution of the present invention.
FIG.16 is a location diagram of a light-heat transmitting layer of the third technical solution of the present invention.
FIG. 17 is a location diagram of an airflow average-temperature equipment of the third technical solution of the present invention.
FIG.18 is a structural diagram of a tubular LED light emitting and heat dissipating body unit of a first embodiment of the third technical solution of the present invention.
FIG. 19 is a side viewed structural diagram of the tubular LED light emitting and heat dissipating body unit of the first embodiment of the third technical solution of the present invention.
FIG.20 is a structural diagram of a tubular LED light emitting and heat dissipating body unit of a second embodiment of the third technical solution of the present invention.
FIG.21 is a side viewed structural diagram of the tubular LED light emitting and heat dissipating body unit of the second embodiment of the third technical solution of the present invention.
FIG.22 is a structural diagram of the third technical solution of the present invention.

### DETAILED DESCRIPTION OF THE PREFERRED EMBODIMENT

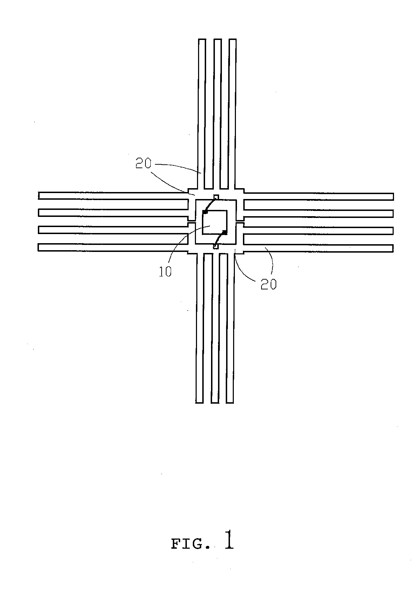

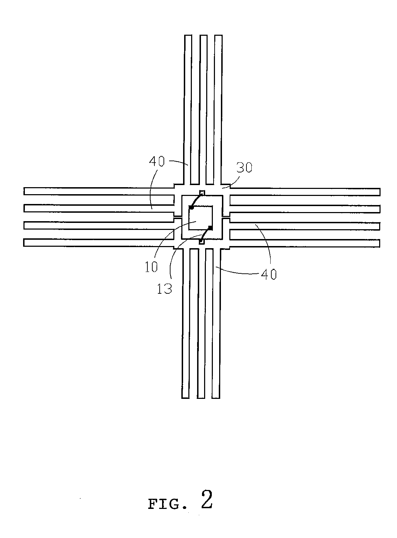

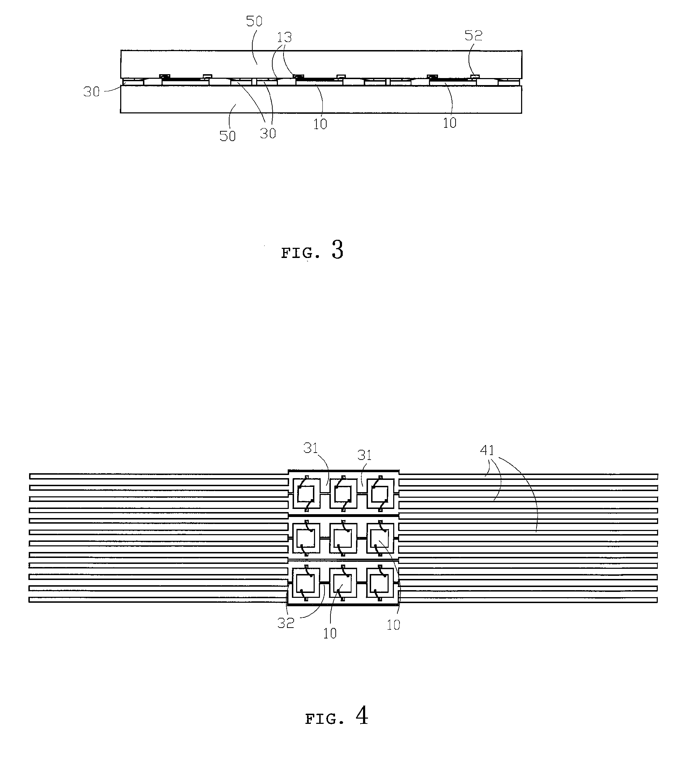

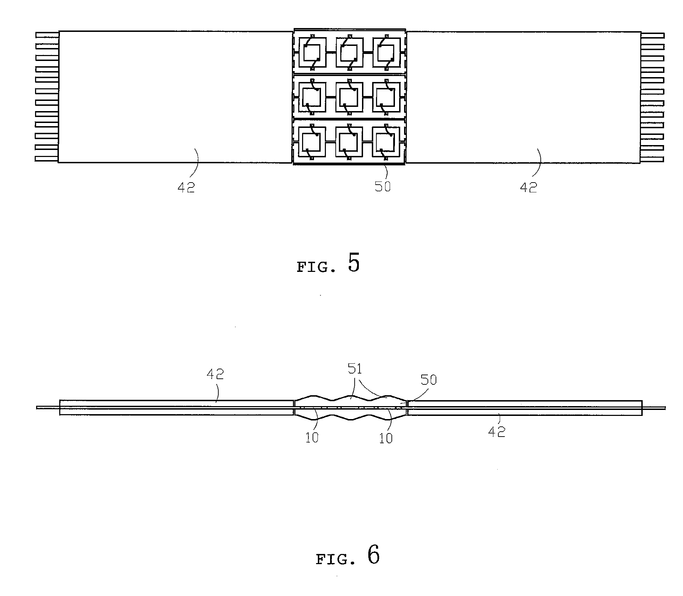

As shown in Fig.1 to Fig.6, An LED light source heat-dissipation structure comprises at least one LED light emitting body 10 and at least one heat dissipating conductor 20, wherein the LED light emitting body 10 comprises a P-type semiconductor and a N-type semiconductor, wherein the P-type semiconductor and the N-type semiconductor define a PN junction, wherein the voltage is applied to two ends of the PN junction to make the PN junction form an energy level (is a series of energy levels, actually) by itself so as to enable electrons to move up from the energy level to produce photons and illuminate.

The LED light emitting body 10 has an upper light emitting surface and a lower light emitting surface.

In a specific embodiment, the LED light emitting body 10 can employ a flip structure, wherein the LED light emitting body 10 has six light emitting surfaces, which may be orderly overlapped and arranged, wherein the LED light-emitting bodies 10 are orderly overlapped and arranged at a rigid and transparent base layer, a light emitting layer and a current diffusing layer, wherein the flip structure of the LED light-emitting bodies 10 is simple in structure and can define an upper light emitting surface 11 and a lower light emitting surface 12, and the specific structure of the LED light emitting body 10 has been disclosed in PCT. Pat. No. CN2011/000756 and isn't described here.

The heat dissipating conductor 20 is made of an exposed structure having a large heat-dissipation surface. It is well known that a conductor having a good electric -conductive performance always has a good heat-conductive performance, so the idea of heat-dissipation by utilizing the conductor is considered by the present invention to dissipate heat by utilizing the conductor while achieving an electric conduction by utilizing the conductor so as to increase the heat-dissipation effect without adding any additional heat dissipating component.

The main function of the conventional conductor connected with the LED light emitting body is limited to providing power connection, and transferring the power control signals. Being limited by the functions of the conductor, the conventional conductor connected with the LED light emitting body is always packaged in the corresponding circuit board. The dissipation function of the conductor is ignored by the designers, so when a circuit layout for a conventional LED light emitting body is specifically designed, any relevant structure for improving the heat-dissipation function of the conductor isn't considered. In contrast, the circuit layout of the conventional LED light emitting body even further limits the dissipation function of the conductor that the conductor merely plays a very small role in heat-dissipation in practical applications and the heat-dissipation function of the conductor is almost given up. Whereas the inventor of the present invention hammers away at the heat-dissipation problem of the LED light emitting body and an improved conductor structure can greatly enhance the heat-dissipation effect thereof. The outer wall of the conventional conductor connected with the LED light emitting body is always coated with an insulating layer that the heat-dissipation effect is impacted and ignored, so the whole surface area of the conventional conductor is possibly minimized, which is just the opposite of the idea of the present invention. Hence, this patent application is submitted.

The heat dissipating conductor 20 comprises an electrode connection heat conducting and dissipating portion 30 and a signal power transmission heat-dissipation portion 40.

The electrode connection heat conducting-dissipating portion 30 is connected with the signal power transmission heat-dissipation portion 40 to define the heat dissipating conductor 20.

Each of the electrode connection heat conducting-dissipating portion 30 and the signal power transmission heat-dissipation portion 40 is made of an exposed structure having a large heat-dissipation surface.

The heat-dissipation effects of the electrode connection heat conducting-dissipating portion 30 and the signal power transmission heat-dissipation portion 40 can be extremely improved by utilizing the exposed structure having a large heat-dissipation surface.

However, the outer wall of the conventional conductor connected with the LED light emitting body is always coated with an insulating layer, and the heat-dissipation effect is impacted and ignored in the conventional conductor, so the whole surface area of the conventional conductor is possibly minimized, which is just the opposite of the idea of the present invention.

In a specific embodiment, the exposed structures having a large heat-dissipation surface of the electrode connection heat conducting-dissipating portion 30 and the signal power transmission heat-dissipation portion 40 can be achieved by removing any insulating layer and any packaging structure provided on the surfaces of the electrode connection heat conducting-dissipating portion 30 and the signal power transmission heat-dissipation portion 40 of the conductor.

The large heat-dissipation surfaces of the electrode connection heat conducting-dissipating portion 30 and the signal power transmission heat-dissipation portion 40 can be achieved by enhancing the surface areas thereof, for example, the conventional conductor may have a rectangular cross-section and the rectangular cross-section has a transverse width of 1mm, the large heat-dissipation surfaces of the electrode connection heat conducting-dissipating portion 30 and the signal power transmission heat-dissipation portion 40 can be achieved by increasing the transverse width thereof, for example, increasing the transverse width from 1mm to 1cm.

In a specific embodiment, the electrode connection heat conducting-dissipating portion 30 can be defined by the natural extension of the signal power transmission heat-dissipation portion 40. In other words, the external shape of the electrode connection heat conducting-dissipating portion 30 can be equal to the signal power transmission heat-dissipation portion 40, which is merely defined from a structural portion of the signal power transmission heat-dissipation portion 40.

The positive and negative conductors 13 of the LED light emitting body 10 are connected between the LED light emitting body 10 and the electrode connection heat conducting-dissipating portion 30.

The electrode connection heat conducting-dissipating portion 30 is used for transferring the electric current and the control signals from the signal power transmission heat-dissipation portion 40 to the LED light emitting body 10 by the positive and negative conductors 13.

At the same time, the heat generated when the LED light emitting body 10 is energized and emits light is conducted to the electrode connection heat conducting-dissipating portion 30 by the positive and negative conductors 13 and dissipated by the electrode connection heat conducting-dissipating portion 30. Simultaneously, the electrode connection heat conducting-dissipating portion 30 can transfer the heat to the signal power transmission heat-dissipation portion 40 and the heat is outwardly dissipated by the signal power transmission heat-dissipation portion 40 so as to improve greatly the heat-dissipation effect during the LED light emitting body 10 is energized and emits light.

In a specific embodiment, a light-heat transmitting crystal layer 50 cover each of the upper light emitting surface and the lower light emitting surface of the LED light emitting body 10.

The light generated from the LED light emitting body 10 outwardly ejects through the light-heat transmitting crystal layers 50, and at the same time, the heat generated during the LED light emitting body 10 is energized and emits light is transmitted to the light-heat transmitting crystal layers 50 by the upper light emitting surface 11 and the lower light emitting surface 12 and dissipated by the light-heat transmitting crystal layers 50.

Both of the LED light emitting body 10 and the electrode connection heat conducting-dissipating portion 30 are sandwiched between two light-heat transmitting crystal layers 50.

The heat transmitted by the upper light emitting surface 11 and the lower light emitting surface 12 to the light-heat transmitting crystal layers 50 and dissipated by the light-heat transmitting crystal layers 50 can simultaneously be transmitted to the electrode connection heat conducting-dissipating portion 30 and dissipated by the electrode connection heat conducting-dissipating portion 30 and the signal power transmission heat-dissipation portion 40 so as to further improve the dissipation effect of the LED light emitting body 10.

In a specific embodiment, the electrode connection heat conducting-dissipating portion 30, the signal power transmission heat-dissipation portion 40 and the light-heat transmitting crystal layers 50 can dissipate the heat generated from the LED light emitting body 10 by a two-dimensional surface or three-dimensional space structure thereof.

The three-dimensional space structure refers to a three-dimensional space shape for utilizing fully the LED light emitting body 10, and according to the need, the electrode connection heat conducting-dissipating portion 30, the signal power transmission heat-dissipation portion 40 and the light-heat transmitting crystal layers 50 contact with the LED light emitting body 10 in different ways and fully utilize the environmental space surrounding the LED light emitting body 10 to dissipate the heat generated from the LED light emitting body 10. In a specific embodiment, the relative position of these components can be freely adjusted and provided to meet the need of contacting closely and increasing the heat-dissipation surface.

In the present application, the description is merely given to illustrate a plane structure, which is as follows:
Each of the LED light emitting body 10 and the heat dissipating conductor 20 defines a plane structure, and the width of the LED light emitting body 10 is equal to the electrode connection heat conducting-dissipating portion 30.

In order to facilitate processing operations, the LED light emitting body 10, the electrode connection heat conducting-dissipating portion 30 and the signal power transmission heat-dissipation portion 40 can be designed to have an equal width. The LED light emitting body 10 is sandwiched in an interval space between two light-heat transmitting crystal layers 50 and the electrode connection heat conducting-dissipating portion 30 is provided to surround the LED light emitting body 10, wherein the electrode connection heat conducting-dissipating portion 30 is sandwiched between edge portions of the two light-heat transmitting crystal layers 50.

The signal power transmission heat-dissipation portion 40 is radially connected with the electrode connection heat conducting-dissipating portion 30 in a surrounding manner.

In some embodiment, the electrode connection heat conducting-dissipating portion 30 may be simultaneously provided to surround the LED light emitting body 10, and each of the positive and negative conductors 13 of the LED light emitting body 10 is connected with the electrode connection heat conducting-dissipating portion 30, wherein the LED light emitting bodies 10 may be different LED light sources emitting different colored lights.

For example, the electrode connection heat conducting-dissipating portion 30 may simultaneously surround three LED light emitting bodies 10 and the three LED light emitting bodies 10 are respectively a red LED light source, a green LED light source and a blue LED light source and provide a RGB color mode.

The electrode connection heat conducting-dissipating portion 30 is made of light proof material having good heat and electric conductivity and the light generated by the LED light emitting body 10 is only ejected through the light-heat transmitting crystal layer 50, wherein the electrode connection heat conducting-dissipating portion 30 can provide a light shading effect such that when the electrode connection heat conducting-dissipating portion 30 surrounds the LED light emitting body10, the electrode connection heat conducting-dissipating portion 30 can shade and limit light. Hence, the light generated by the LED light emitting body 10 can be limited in a predetermined region by the electrode connection heat conducting-dissipating portion 30 to make the light eject only through the light-heat transmitting crystal layer 50 so as to avoid the light being excessively scattered, defining a fuzzy region surrounding the LED light emitting body 10 and reducing the whole resolution thereof.

Further, the electrode connection heat conducting-dissipating portion 30 is made of light reflection material having good heat and electric conductivity and the light ejected on the electrode connection heat conducting-dissipating portion 30 can be reflected by utilizing the light reflection performance of the electrode connection heat conducting-dissipating portion 30 and rejects through the light-heat transmitting crystal layer 50 to improve the light utilization efficiency of the LED light emitting body 10, wherein the light is generated from the LED light emitting body10.

In a specific embodiment, the electrode connection heat conducting-dissipating portion 30 comprises an inner copper layer and an external silver layer, wherein the external silver layer encloses the inner copper layer and the outer surface of the silver layer is a mirror surface.

The light reflection material is defined by the external silver layer and the inner copper layer.

For the conveniences of processing and manufacturing, the electrode connection heat conducting-dissipating portion 30 and the signal power transmission heat-dissipation portion 40 are designed to have a consistent layer structure.

When the electrode connection heat conducting-dissipating portion 30 is provided to surround multiple LED light emitting bodies 10, a plurality of insulating plates 31 are outwardly extended from the electrode connection heat conducting-dissipating portion 30 respectively and the insulating plates 31 are spacedly provided between every two neighboring LED light emitting bodies10, wherein the insulating plates 31 are capable of insulating different lights from the neighboring LED light emitting bodies 10 to prevent the different lights being mixed.

In order to facilitate the circuit design, the electrode connection heat conducting-dissipating portion 30 has a plurality of insulating outlets 32 provided thereat, wherein the correct electric connection of the heat dissipating conductor 20 can be ensured by the insulating outlets 32 to avoid the short circuit generated from the direct connection of the positive and the negative ends. In addition, the insulating outlets 32 are also used for separating the conductors having different electric control signals to make the different electric control signals be accurately transferred.

In a specific embodiment, the signal power transmission heat-dissipation portion 40 comprises multiple signal power transmission heat-dissipation wires 41, which are provided to surround the electrode connection heat conducting-dissipating portion 30, as required.

In a specific embodiment, the signal power transmission heat-dissipation wires 41 are connected to a power supply and signal control module. Hence, the signal power transmission heat-dissipation wires 41 can be used for transmitting the electric current, the electric control signals and the heat-dissipation.

In a specific embodiment, the light-heat transmitting crystal layer 50 further comprises a plurality of optical protruding platforms 51, wherein the optical protruding platforms 51 are extended for the surface of the light-heat transmitting crystal layer 50, wherein the optical protruding platforms 51 are corresponding to the LED light emitting bodies 10. The optical protruding platforms 51 can be pyramid-shaped or semicircular, which benefits the light collection and compensates the disadvantage generated from different reflective indexes of the light-heat transmitting crystal layer 50 and the external environment thereof. In addition, the light-heat transmitting crystal layer 50 further has a plurality of grooves 52 provided at the inner surface of the light-heat transmitting crystal layer 50, wherein the electric connecting portions of the positive and negative conductors 13, which are used for connecting to the electrode connection heat conducting-dissipating portion 30, may be received in the grooves 52 to enable the light-heat transmitting crystal layer 50 to cover stably the LED light emitting bodies 10 and the electrode connection heat conducting-dissipating portion 30.

In a specific embodiment, the signal power transmission heat-dissipation wires 41 of the signal power transmission heat-dissipation portion 40 are radially provided and surround the electrode connection heat conducting-dissipating portion 30. In order to enhance the strength of the signal power transmission heat-dissipation wires 41, the spatial position and form of the signal power transmission heat-dissipation wires 41 can be fixed.

In a specific embodiment, two fixing dissipation plates 42 are provided to sandwich the signal power transmission heat-dissipation portion 40 at the upper side and the bottom side thereof, wherein the fixing dissipation plates 42 are made of heat conducting-dissipating insulation material, for example, ceramic material, plastic material or other heat conducting-dissipating insulation materials.

In order to avoid influencing the illumination effect of the LED light emitting body 10, the fixing dissipation plates 42 are made of transparent heat conducting-dissipating insulation material, for example, glass material. The fixing dissipation plate 42 made of glass material can assist in dissipating outwardly the heat thereof in a radiation manner and make a user fail to feel a black spot in the light source by utilizing the light transmission performance of the fixing dissipation plate 42 made of glass material when he observes the LED light source of the present invention.

As shown in Figs.1 to 6, a heat dissipating method for LED light resources is provided, which comprises the step of: arranging the heat dissipating conductor 20 to surround the LED light emitting body 10, wherein the LED light emitting body comprises a P-type semiconductor and a N-type semiconductor, wherein the P-type semiconductor and the N-type semiconductor define a PN junction.

The heat dissipating conductor 20 is made of the exposed structure having a large heat-dissipation surface, wherein the heat dissipating conductor 20 comprises an electrode connection heat conducting and dissipating portion 30 and a signal power transmission heat-dissipation portion 40.

The electrode connection heat conducting-dissipating portion 30 is connected with the signal power transmission heat-dissipation portion 40 to define the heat dissipating conductor 20.

Each of the electrode connection heat conducting-dissipating portion 30 and the signal power transmission heat-dissipation portion 40 is respectively made of an exposed structure having a large heat-dissipation surface.

The exposed structures having a large heat-dissipation surface can greatly improve the heat dissipation and conduction effect of the electrode connection heat conducting and dissipating portion 30 and the signal power transmission heat-dissipation portion 40.

The positive and negative conductors 13 of the LED light emitting body 10 is provided between the LED light emitting body 10 and the electrode connection heat conducting-dissipating portion 30.

The electrode connection heat conducting-dissipating portion 30 is used for transferring the electric current and the control signals from the signal power transmission heat-dissipation portion 40 to the LED light emitting body 10 by the positive and negative conductors 13.

At the same time, the heat generated when the LED light emitting body 10 is energized and emits light is conducted to the electrode connection heat conducting-dissipating portion 30 by the positive and negative conductors 13 and dissipated by the electrode connection heat conducting-dissipating portion 30. Simultaneously, the electrode connection heat conducting-dissipating portion 30 can further transfer the heat to the signal power transmission heat-dissipation portion 40 and the heat is outwardly dissipated by the signal power transmission heat-dissipation portion 40.

The LED light emitting body 10 comprises an upper light emitting surface 11 and a lower light emitting surface 12, wherein each of the upper light emitting surface 11 and the lower light emitting surface 12 of the LED light emitting body 10 are respectively covered by a light-heat transmitting crystal layer 50.

The light generated from the LED light emitting body 10 outwardly ejects through the light-heat transmitting crystal layers 50, and at the same time, the heat generated during the LED light emitting body 10 is energized and emits light is transmitted to the light-heat transmitting crystal layers 50 by the upper light emitting surface 11 and the lower light emitting surface 12 and dissipated by the light-heat transmitting crystal layers 50.

Both of the LED light emitting body 10 and the electrode connection heat conducting-dissipating portion 30 are sandwiched between two light-heat transmitting crystal layers 50.

The heat transmitted by the upper light emitting surface 11 and the lower light emitting surface 12 to the light-heat transmitting crystal layers 50 and dissipated by the light-heat transmitting crystal layers 50 can simultaneously be transmitted to the electrode connection heat conducting-dissipating portion 30 and dissipated by the electrode connection heat conducting-dissipating portion 30 and the signal power transmission heat-dissipation portion 40. The LED light emitting body 10 is sandwiched in an interval space between two light-heat transmitting crystal layers 50 and the electrode connection heat conducting-dissipating portion 30 is provided to surround the LED light emitting body 10, wherein the electrode connection heat conducting-dissipating portion 30 is sandwiched between edge portions of the two light-heat transmitting crystal layers 50.

The signal power transmission heat-dissipation portion 40 is radially connected with the electrode connection heat conducting-dissipating portion 30 in a surrounding manner.

The electrode connection heat conducting-dissipating portion 30 is made of light proof material having good heat and electric conductivity and the light generated by the LED light emitting body 10 is only ejected through the light-heat transmitting crystal layer 50, wherein the electrode connection heat conducting-dissipating portion 30 can provide a light shading effect such that when the electrode connection heat conducting-dissipating portion 30 surrounds the LED light emitting body10, the electrode connection heat conducting-dissipating portion 30 can shade and limit light. Hence, the light generated by the LED light emitting body 10 can be limited in a predetermined region by the electrode connection heat conducting-dissipating portion 30 to make the light eject only through the light-heat transmitting crystal layer 50 so as to avoid the light being excessively scattered, defining a fuzzy region surrounding the LED light emitting body 10 and reducing the whole resolution thereof.

The signal power transmission heat-dissipation portion 40 comprises multiple signal power transmission heat-dissipation wires 41, which are provided to surround the electrode connection heat conducting-dissipating portion 30 and used for transmitting the electric current, the electric control signals and the heat-dissipation.

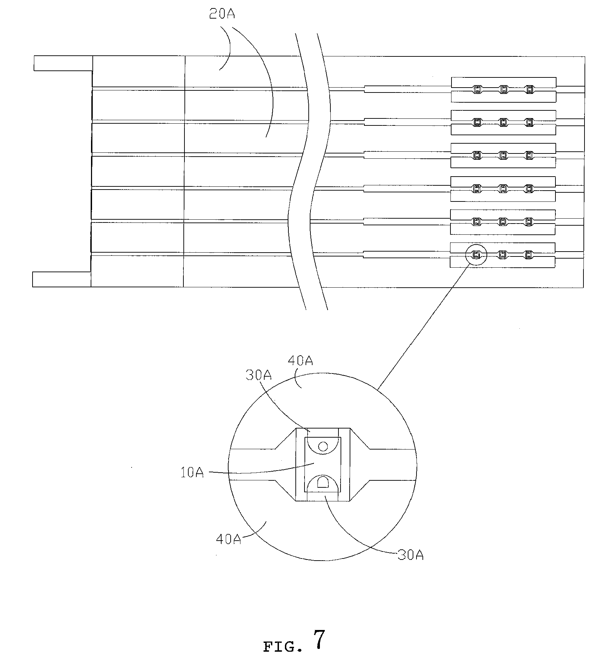

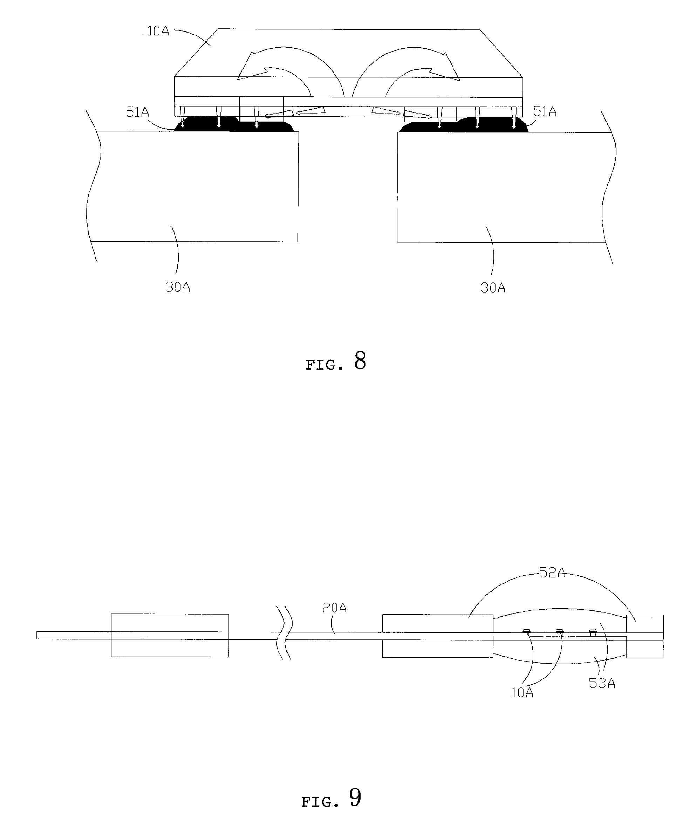

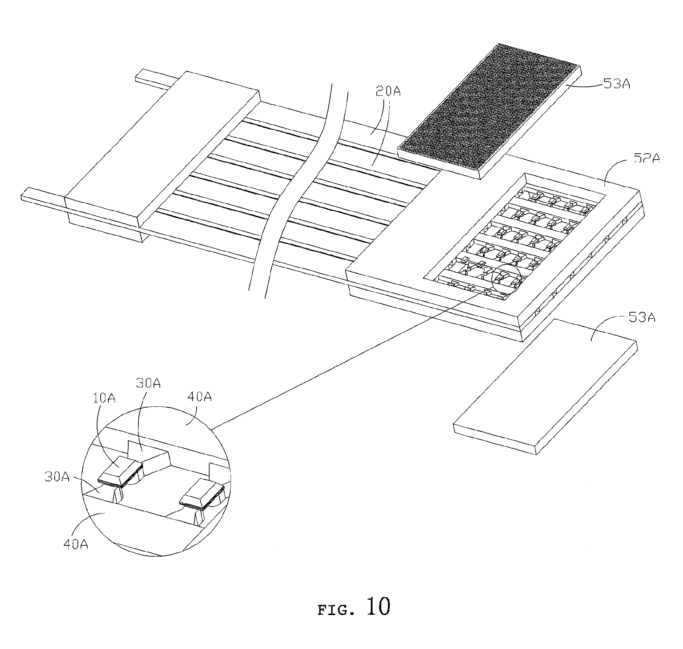

As shown in Figs.7 to 14, the second technical solution of the present invention, a heat-dissipation structure for an LED light source is provided, which comprises at least one LED light emitting body 10A and at least one heat dissipating conductor 20A, wherein the LED light emitting body 10A comprises a P-type semiconductor and a N-type semiconductor, wherein the P-type semiconductor and the N-type semiconductor define a PN junction, wherein the voltage is applied to two ends of the PN junction to make the PN junction form an energy level (is a series of energy levels, actually) by itself so as to enable electrons to move up from the energy level to produce photons and illuminate.

The LED light emitting body 10A has an upper light emitting surface and a lower light emitting surface.

In a specific embodiment, the LED light emitting body 10A can employ a flip structure, wherein the LED light emitting body 10A has six light emitting surfaces, which may be orderly overlapped and arranged, wherein the LED light-emitting bodies 10A are orderly overlapped and arranged at a rigid and transparent base layer, a light emitting layer and a current diffusing layer, wherein the flip structure of the LED light-emitting bodies 10A is simple in structure and can define an upper light emitting surface 11A and a lower light emitting surface 12A, and the specific structure of the LED light emitting body 10A has been disclosed in PCT. Pat. No. CN2011/000756 and isn't described here.

The heat dissipating conductor 20A is made of an exposed structure having a large heat-dissipation surface. It is well known that a conductor having a good electric -conductive performance always has a good heat-conductive performance, so the idea of heat-dissipation by utilizing the conductor is considered by the present invention to dissipate heat by utilizing the conductor while achieving an electric conduction by utilizing the conductor so as to increase the heat-dissipation effect without adding any additional heat dissipating component.

The main function of the conventional conductor connected with the LED light emitting body is limited to providing power connection, and transferring the power control signals. Being limited by the functions of the conductor, the conventional conductor connected with the LED light emitting body is always packaged in the corresponding circuit board. The dissipation function of the conductor is ignored by the designers, so when a circuit layout for a conventional LED light emitting body is specifically designed, any relevant structure for improving the heat-dissipation function of the conductor isn't considered. In contrast, the circuit layout of the conventional LED light emitting body even further limits the dissipation function of the conductor that the conductor merely plays a very small role in heat-dissipation in practical applications and the heat-dissipation function of the conductor is almost given up. Whereas the inventor of the present invention hammers away at the heat-dissipation problem of the LED light emitting body and an improved conductor structure can greatly enhance the heat-dissipation effect thereof. The outer wall of the conventional conductor connected with the LED light emitting body is always coated with an insulating layer that the heat-dissipation effect is impacted and ignored, so the whole surface area of the conventional conductor is possibly minimized, which is just the opposite of the idea of the present invention. Hence, this patent application is submitted.

The heat dissipating conductor 20A comprises a conducting and transferring portion 30A for holding the LED light emitting body 10A and a signal power transmission heat-dissipation portion 40A. The conducting and transferring portion 30A is fixed at the signal power transmission heat-dissipation portion 40A, wherein the LED light emitting body 10A is held at the conducting and transferring portion 30A.

The conducting and transferring portion 30A and the signal power transmission heat-dissipation portion 40A respectively made of an exposed structure having a large heat-dissipation surface. The exposed structures having a large heat-dissipation surface are employed to enhance greatly the heat conduction-dissipation effect of the conducting and transferring portion 30A and the signal power transmission heat-dissipation portion 40A. The exterior of the conventional conductor connected with the LED light emitting body is always coated with an insulating layer that the heat-dissipation effect is impacted and ignored, so the whole surface area of the conventional conductor is possibly minimized to reduce the whole size of the circuit board, which is just the opposite of the idea of the present invention.

In a specific embodiment, the exposed structures having a large heat-dissipation surface of the conducting and transferring portion 30A and the signal power transmission heat-dissipation portion 40A can be achieved by removing any insulating layer and any packaging structure provided on the surfaces of the electrode connection heat conducting-dissipating portion 30A and the signal power transmission heat-dissipation portion 40A of the conductor.

The conducting and transferring portion 30A fixes the LED light emitting body 10A at a position, which simultaneously enhances the heat transmission contact surface between the heat dissipating conductor 20A and the LED light emitting body 10A. In addition, the conducting and transferring portion 30A can also transfer the electric current and the control signals from the signal power transmission heat-dissipation portion 40A to the LED light emitting body 10A.

In other words, the conductor between the LED light emitting body 10A and the heat dissipating conductor 20A is cancelled, and the conducting and transferring portion 30A is used for providing the original function of the conductor. The advantage of the replacement is that the conducting and transferring portion 30A can be not only utilized for conducting the electric current and the control signals, it can also fix the spatial position of the LED light emitting body 10A and increase the thermal conduction contact surface between the heat-dissipation conductor 20A and the LED light emitting body 10A.

The large heat-dissipation surfaces of the conducting and transferring portion 30A and the signal power transmission heat-dissipation portion 40A can be achieved by increasing the surface areas thereof, for example, the conventional conductor may have a rectangular cross-section and the rectangular cross-section has a transverse width of 1mm, the large heat-dissipation surfaces of the electrode connection heat conducting-dissipating portion 30A and the signal power transmission heat-dissipation portion 40A can be achieved by increasing the transverse width thereof, for example, increasing the transverse width from 1mm to 1cm.

In a specific embodiment, the conducting and transferring portion 30A can be defined by the natural extension of the signal power transmission heat-dissipation portion 40A. In other words, the conducting and transferring portion 30A is merely defined from a structural portion of the signal power transmission heat-dissipation portion 40A.

The heat generated when the LED light emitting body 10 is energized to emit light is directly conducted to the conducting and transferring portion 30A and dissipated by the conducting and transferring portion 30A. Simultaneously, the conducting and transferring portion 30A can transfer the heat to the signal power transmission heat-dissipation portion 40A and the heat is outwardly dissipated by the signal power transmission heat-dissipation portion 40A so as to improve greatly the heat-dissipation effect during the LED light emitting body 10A is energized to emit light.

In the specific application, there are various embodiments to achieve the above technical solutions, which are respectively described as follows:
As shown in Figs.7 to 10, a first embodiment, a non-wire welding mode for an LED chip having a flip structure, is illustrated.

The LED light emitting body 10A can be flipped and held between any two neighboring heat dissipating conductors 20A, wherein the signal power transmission heat-dissipation portion 40A has a top surface, a bottom surface and an external side, wherein the external side extended between the top surface and the bottom surface.

The conducting and transferring portion 30A is extended and protruded from the external side of the signal power transmission heat-dissipation portion 40A. The conducting and transferring portions 30A held respectively between any two neighboring signal power transmission heat-dissipation portions 40A correspond with each other.

Each of the LED light emitting bodies 10A is held between any two neighboring signal power transmission heat-dissipation portions 40A, and the LED light emitting body 10A is held at the conducting and transferring portions 30A provided between any two neighboring signal power transmission heat-dissipation portions 40A.

A p-junction and an n-junction of the LED light emitting body 10A are respectively connected with the conducting and transferring portions 30A for holding the LED light emitting body 10A. In order to increase the electric-heat conduction effect between the LED light emitting body 10A and the conducting and transferring portions 30A for holding the LED light emitting body 10A, a silver paste layer 51A is provided between the LED light emitting body 10A and the conducting and transferring portions 30A for holding the LED light emitting body 10A.

In order to increase the heat-dissipation effect of the signal power transmission heat-dissipation portions 40A, two thermal radiation layers 52A are respectively provided to sandwich the signal power transmission heat-dissipation portion 40A at two sides thereof, which can be made of glass material, stoving varnish material, plastic material, ceramic material or other materials having good radiation performance.

In order to increase the heat-dissipation effect and optical performance of the LED light emitting body 10A, two transparent heat-dissipation layers 53A are respectively provided to sandwich the LED light emitting body 10A at two sides thereof, wherein each of the transparent heat-dissipation layers 53A may be a YAG layer containing cerium, a phosphor silica gel layer or a sapphire crystal layer or so on. In addition, the material of each of the transparent heat-dissipation layers 53A can be respectively determined as required, for example, one transparent heat-dissipation layer 53A is a phosphor silica gel layer, and another is a sapphire crystal layer.

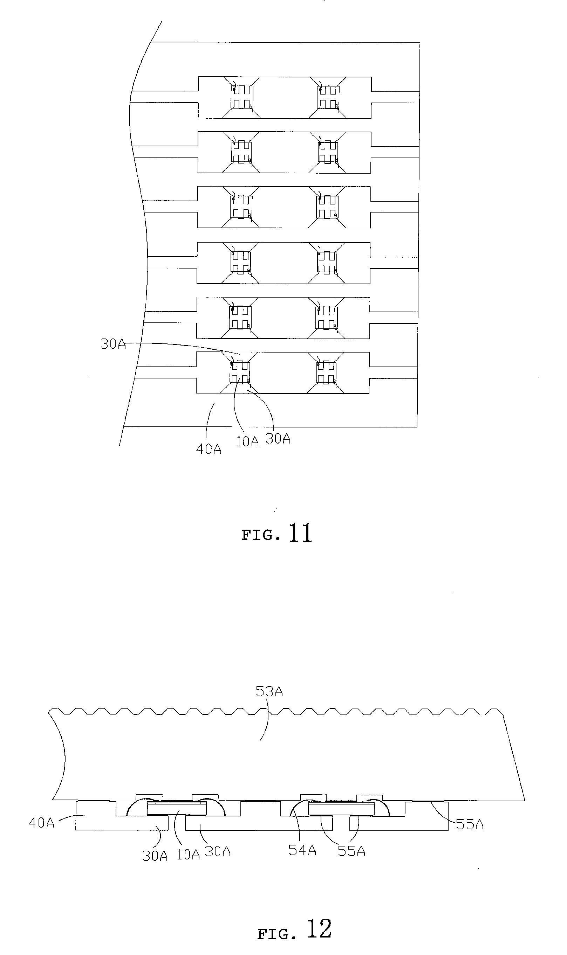

As shown in Figs. 11 to 12, a second embodiment, a wire welding mode for a normal DA LED chip, is illustrated.

The LED light emitting body 10A can be normally held between any two neighboring heat dissipating conductors 20A, wherein the signal power transmission heat-dissipation portion 40A has a top surface, a bottom surface and an external side, wherein the external side extended between the top surface and the bottom surface.

The conducting and transferring portion 30A is extended and protruded from the external side of the signal power transmission heat-dissipation portion 40A. The conducting and transferring portions 30A held respectively between any two neighboring signal power transmission heat-dissipation portions 40A correspond with each other.

Each of the LED light emitting bodies 10A is held between any two neighboring signal power transmission heat-dissipation portions 40A, and the LED light emitting body 10A is held at the conducting and transferring portions 30A provided between any two neighboring signal power transmission heat-dissipation portions 40A.

A p-junction and an n-junction of the LED light emitting body 10A are respectively connected with the conducting and transferring portions 30A for holding the LED light emitting body 10A by a conductor 54A.

In order to increase the heat-dissipation effect of the signal power transmission heat-dissipation portions 40A, two thermal radiation layers 52A are respectively provided to sandwich the signal power transmission heat-dissipation portion 40A at two sides thereof, which can be made of glass material, stoving varnish material, plastic material, ceramic material or other materials having good radiation performance.

In order to increase the heat-dissipation effect and optical performance of the LED light emitting body 10A, two transparent heat-dissipation layers 53A are respectively provided to sandwich the LED light emitting body 10A at two sides thereof, wherein each of the transparent heat-dissipation layers 53A may be a YAG layer containing cerium, a silica layer or phosphor silica gel layer, a YAG layer, an aluminum nitride crystal layer, or a sapphire crystal layer or so on. In addition, the material of each of the transparent heat-dissipation layers 53A can be respectively determined as required, for example, when the LED light source is used as a lamp for plant growing or producing white lights by mixing RGB lights, one transparent heat-dissipation layer 53A can be a phosphor silica gel layer, and another can be a sapphire crystal layer.

In order to increase the heat-conduction effect of each part, a heat-conducting adhesive layer 55A is provided between the transparent heat-dissipation layer 53A and the LED light emitting body 10A and/or between the LED light emitting body 10A and the conducting and transferring portions 30A.

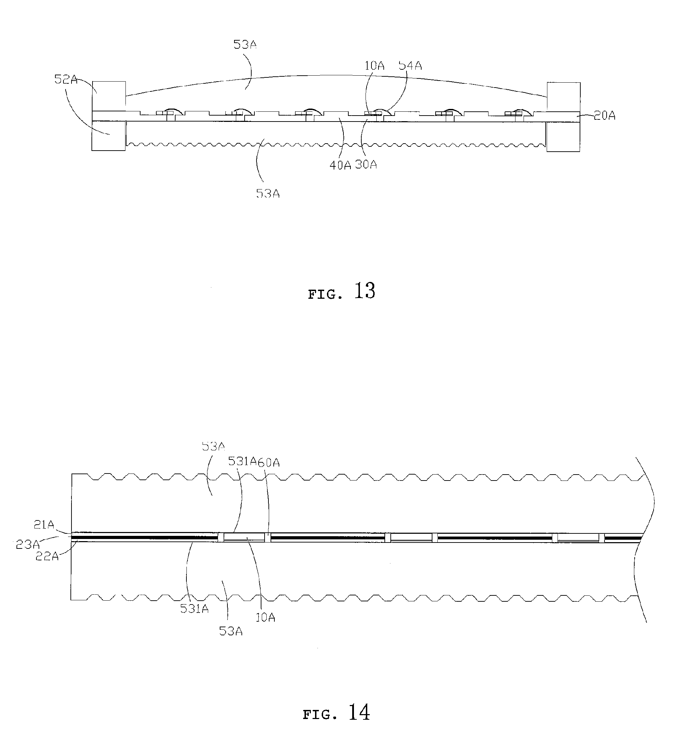

As shown in Fig. 13, a third embodiment, an individual wire welding mode for a normal DA LED chip, is illustrated.

The LED light emitting body 10A can be held between any two neighboring heat dissipating conductors 20A, wherein the signal power transmission heat-dissipation portion 40A has a top surface, a bottom surface and an external side, wherein the external side extended between the top surface and the bottom surface.

The conducting and transferring portion 30A is extended and protruded from the external side of the signal power transmission heat-dissipation portion 40A.

The LED light emitting body 10A is held at the conducting and transferring portions 30A, wherein the LED light emitting body 10A is held by the conducting and transferring portion 30A of one heat dissipating conductor 20A by itself.

The p-junction and n-junction of the LED light emitting body 10A are respectively connected with the signal power transmission heat-dissipation portion 40A of another heat dissipating conductor 20A.

As shown in Fig.14, a forth embodiment, a vertical bonding mode, is illustrated.

The heat dissipating conductor 20A comprises a first conducting layer 21A, a second conducting layer 22A and an insulating layer 23A, wherein the first conducting layer 21A, the second conducting layer 22A and the insulating layer 23A are provided in a stacked manner, and the insulating layer 23A is sandwiched between the first conducting layer 21A and the second conducting layer 22A, wherein the first conducting layer 21A and the second conducting layer 22A are electrically isolated from each other by the insulating layer 23A. Specifically, the first conducting layer 21A and the second conducting layer 22A are respectively used as a positive end and a negative end.

The heat dissipating conductor 20A is further sandwiched between two transparent heat-dissipation layers 53A, wherein the transparent heat-dissipation layer 53A comprises an electric conduction layer 531A provided at a contact surface of the transparent heat-dissipation layer 53A, which contacts the heat dissipating conductor 20A.

Any two neighboring heat dissipating conductors 20A define a light resource chamber 60A.

The LED light emitting body 10A is sandwiched in the light resource chamber 60A.

The p-junction and n-junction of the LED light emitting body 10A are respectively connected with the first conducting layer 21A and the second conducting layer 22A by the electric conduction layers 531A.

The first conducting layer 21A and the second conducting layer 22A define the signal power transmission heat-dissipation portion 40A, and the two transparent heat-dissipation layers 53A and the electric conduction layers 531A thereof define the conducting and transferring portion 30A.

In a specific embodiment, a heat radiation layer is coated on the surface each of the first conducting layer 21A and the second conducting layer 22A to enhance radiant heat-dissipation effect thereof, wherein the heat radiation layer can be made of glass powder material, ceramic powder material or plastic powder material.

In order to increase the heat-dissipation effect of the signal power transmission heat-dissipation portions 40A defined by the first conducting layer 21A and the second conducting layer 22A, two thermal radiation layer 52A are respectively provided to sandwich the signal power transmission heat-dissipation portion 40A at two sides thereof, which can be made of glass material, ceramic material or other materials having good radiation performance.

In a specific embodiment, the conducting and transferring portion 30A and the signal power transmission heat-dissipation portion 40A can dissipate the heat generated from the LED light emitting body 10A by a two-dimensional surface or three-dimensional space structure thereof.

The three-dimensional space structure refers to a three-dimensional space shape for utilizing fully the LED light emitting body 10A, and according to the need, the conducting and transferring portion 30A and the signal power transmission heat-dissipation portion 40A contact with the LED light emitting body 10A in different ways and fully utilize the environmental space surrounding the LED light emitting body 10A to dissipate the heat generated from the LED light emitting body 10A in all direction. In a specific embodiment, the relative positions of these components can be freely adjusted and provided to meet the need of contacting closely and increasing the heat-dissipation surface. As mentioned above, the description is merely given to illustrate a plane structure here.

In a specific embodiment, multiple LED light emitting bodies 10A are employed and the structure of the corresponding heat dissipating conductor 20A is designed, as required, for example, the three LED light emitting bodies 10A are respectively a red LED light source, a green LED light source and a blue LED light source, which provide a RGB color mode.

In a specific embodiment, each of the conducting and transferring portion 30A and the signal power transmission heat-dissipation portion 40A comprises an inner copper layer and an external silver layer, wherein the external silver layer encloses the inner copper layer and the outer surface of the silver layer is a mirror surface.

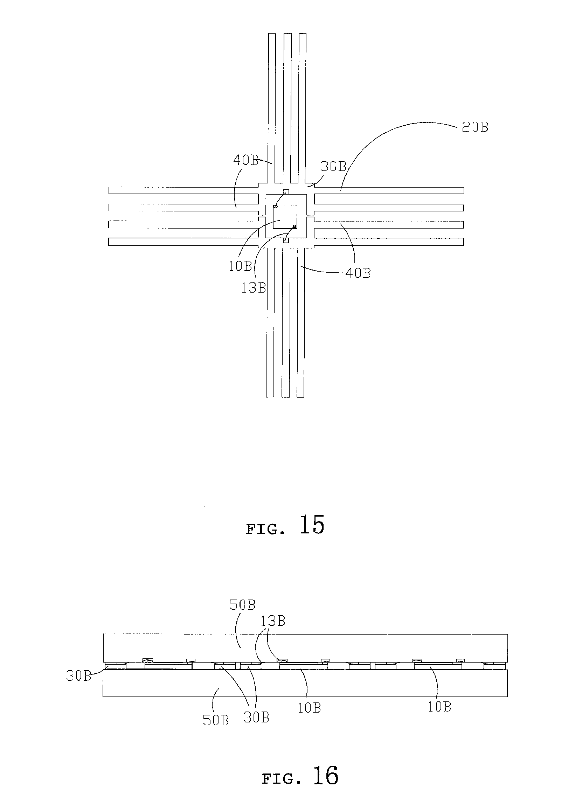

As shown in Fig.15, a third technical solution of the present invention is as follows: An LED light source heat-dissipation structure comprises at least one LED light emitting body 10B and at least one heat dissipating conductor 20B, wherein the LED light emitting body 10B comprises a P-type semiconductor and a N-type semiconductor, wherein the P-type semiconductor and the N-type semiconductor define a PN junction, wherein the voltage is applied to two ends of the PN junction to make the PN junction form an energy level (is a series of energy levels, actually) by itself so as to enable electrons to move up from the energy level to produce photons and illuminate. The LED light emitting body 10B has an upper light emitting surface and a lower light emitting surface.

In a specific embodiment, the LED light emitting body 10B can employ a flip structure, wherein the LED light emitting body 10B has six light emitting surfaces, which may be orderly overlapped and arranged, wherein the LED light-emitting bodies 10B are orderly overlapped and arranged at a rigid and transparent base layer, a light emitting layer and a current diffusing layer, wherein the flip structure of the LED light-emitting bodies 10B is simple in structure and can define an upper light emitting surface 11B and a lower light emitting surface 12B, and the specific structure of the LED light emitting body 10B has been disclosed in PCT. Pat. No. CN2011/000756 and isn't described here.

The heat dissipating conductor 20B is made of an exposed structure having a large heat-dissipation surface. It is well known that a conductor having a good electric -conductive performance always has a good heat-conductive performance, so the idea of heat-dissipation by utilizing the conductor is considered by the present invention to dissipate heat by utilizing the conductor while achieving an electric conduction by utilizing the conductor so as to increase the heat-dissipation effect without adding any additional heat dissipating component.

The main function of the conventional conductor connected with the LED light emitting body is limited to providing power connection, and transferring the power control signals. Being limited by the functions of the conductor, the conventional conductor connected with the LED light emitting body is always packaged in the corresponding circuit board. The dissipation function of the conductor is ignored by the designers, so when a circuit layout for a conventional LED light emitting body is specifically designed, any relevant structure for improving the heat-dissipation function of the conductor isn't considered. In contrast, the circuit layout of the conventional LED light emitting body even further limits the dissipation function of the conductor that the conductor merely plays a very small role in heat-dissipation in practical applications and the heat-dissipation function of the conductor is almost given up. Whereas the inventor of the present invention hammers away at the heat-dissipation problem of the LED light emitting body and an improved conductor structure can greatly enhance the heat-dissipation effect thereof. The outer wall of the conventional conductor connected with the LED light emitting body is always coated with an insulating layer that the heat-dissipation effect is impacted and ignored, so the whole surface area of the conventional conductor is possibly minimized, which is just the opposite of the idea of the present invention.

The heat dissipating conductor 20B comprises an electrode connection heat conducting and dissipating portion 30B and a signal power transmission heat-dissipation portion 40B.The electrode connection heat conducting-dissipating portion 30B is connected with the signal power transmission heat-dissipation portion 40B to define the heat dissipating conductor 20B.

Each of the electrode connection heat conducting-dissipating portion 30B and the signal power transmission heat-dissipation portion 40B is made of an exposed structure having a large heat-dissipation surface.

The heat-dissipation effects of the electrode connection heat conducting-dissipating portion 30B and the signal power transmission heat-dissipation portion 40B can be extremely improved by utilizing the exposed structure having a large heat-dissipation surface.

However, the outer wall of the conventional conductor connected with the LED light emitting body is always coated with an insulating layer, and the heat-dissipation effect is impacted and ignored in the conventional conductor, so the whole surface area of the conventional conductor is possibly minimized, which is just the opposite of the idea of the present invention.

In a specific embodiment, the exposed structures having a large heat-dissipation surface of the electrode connection heat conducting-dissipating portion 30B and the signal power transmission heat-dissipation portion 40B can be achieved by removing any insulating layer and any packaging structure provided on the surfaces of the electrode connection heat conducting-dissipating portion 30B and the signal power transmission heat-dissipation portion 40B of the conductor.

The large heat-dissipation surfaces of the electrode connection heat conducting-dissipating portion 30B and the signal power transmission heat-dissipation portion 40B can be achieved by enhancing the surface areas thereof, for example, the conventional conductor may have a rectangular cross-section and the rectangular cross-section has a transverse width of 1mm, the large heat-dissipation surfaces of the electrode connection heat conducting-dissipating portion 30B and the signal power transmission heat-dissipation portion 40B can be achieved by increasing the transverse width thereof, for example, increasing the transverse width from 1mm to 1 cm.

In a specific embodiment, the electrode connection heat conducting-dissipating portion 30B can be defined by the natural extension of the signal power transmission heat-dissipation portion 40B. In other words, the external shape of the electrode connection heat conducting-dissipating portion 30B can be equal to the signal power transmission heat-dissipation portion 40B, which is merely defined from a structural portion of the signal power transmission heat-dissipation portion 40B.

The positive and negative conductors 13B of the LED light emitting body 10B are connected between the LED light emitting body 10B and the electrode connection heat conducting-dissipating portion 30B.

The electrode connection heat conducting-dissipating portion 30B is used for transferring the electric current and the control signals from the signal power transmission heat-dissipation portion 40B to the LED light emitting body 10B by the positive and negative conductors 13B.

At the same time, the heat generated when the LED light emitting body 10B is energized and emits light is conducted to the electrode connection heat conducting-dissipating portion 30B by the positive and negative conductors 13B and dissipated by the electrode connection heat conducting-dissipating portion 30B. Simultaneously, the electrode connection heat conducting-dissipating portion 30B can transfer the heat to the signal power transmission heat-dissipation portion 40B and the heat is outwardly dissipated by the signal power transmission heat-dissipation portion 40B so as to improve greatly the heat-dissipation effect during the LED light emitting body 10B is energized and emits light.

As shown in Fig.16, in a specific embodiment, each of the upper light emitting surface 11B and the lower light emitting surface 12B of the LED light emitting body 10B are respectively covered by a light-heat transmitting crystal layer 50B, wherein each of the transparent heat-dissipation layers 53B can be a light-heat transmitting crystal layer, a transparent silica gel layer, a fluorescence colloform layer and so on, wherein the transparent heat-dissipation layers 53B may be made of transparent crystal material, ceramic material, glass material, aluminum nitride material or sapphire material and so on. The light generated from the LED light emitting body 10B outwardly ejects through the light-heat transmitting crystal layers 50B, and at the same time, the heat generated during the LED light emitting body 10B is energized and emits light is transmitted to the light-heat transmitting crystal layers 50B by the upper light emitting surface 11B and the lower light emitting surface 12B and dissipated by the light-heat transmitting crystal layers 50B.

Both of the LED light emitting body 10B and the electrode connection heat conducting-dissipating portion 30B are sandwiched between two light-heat transmitting crystal layers 50B.

The heat transmitted by the upper light emitting surface 11 B and the lower light emitting surface 12B to the light-heat transmitting crystal layers 50B and dissipated by the light-heat transmitting crystal layers 50B can simultaneously be transmitted to the electrode connection heat conducting-dissipating portion 30B and dissipated by the electrode connection heat conducting-dissipating portion 30B and the signal power transmission heat-dissipation portion 40B so as to further improve the dissipation effect of the LED light emitting body 10B.

The LED light emitting body 10B is sandwiched in an interval space between two light-heat transmitting crystal layers 50B and the electrode connection heat conducting-dissipating portion 30B is provided to surround the LED light emitting body 10B, wherein the electrode connection heat conducting-dissipating portion 30B is sandwiched between edge portions of the two light-heat transmitting crystal layers 50B.

In a specific embodiment, the electrode connection heat conducting-dissipating portion 30 may be simultaneously provided to surround the LED light emitting body 10, and each of the positive and negative conductors 13 of the LED light emitting body 10 is connected with the electrode connection heat conducting-dissipating portion 30, wherein the LED light emitting bodies 10 may be different LED light sources emitting different colored lights.

For example, the electrode connection heat conducting-dissipating portion 30B may simultaneously surround three LED light emitting bodies 10B and the three LED light emitting bodies 10B are respectively a red LED light source, a green LED light source and a blue LED light source and provide a RGB color mode.

The electrode connection heat conducting-dissipating portion 30B is made of light proof material having good heat and electric conductivity and the light generated by the LED light emitting body 10B is only ejected through the light-heat transmitting crystal layer 50B, wherein the electrode connection heat conducting-dissipating portion 30B can provide a light shading effect such that when the electrode connection heat conducting-dissipating portion 30B surrounds the LED light emitting body 10B, the electrode connection heat conducting-dissipating portion 30B can shade and limit light. Hence, the light generated by the LED light emitting body 10B can be limited in a predetermined region by the electrode connection heat conducting-dissipating portion 30B to make the light eject only through the light-heat transmitting crystal layer 50B so as to avoid the light being excessively scattered, defining a fuzzy region surrounding the LED light emitting body 10B and reducing the whole resolution thereof.

Further, the electrode connection heat conducting-dissipating portion 30B is made of light reflection material having good heat and electric conductivity and the light ejected on the electrode connection heat conducting-dissipating portion 30B can be reflected by utilizing the light reflection performance of the electrode connection heat conducting-dissipating portion 30B and rejects through the light-heat transmitting crystal layer 50B to improve the light utilization efficiency of the LED light emitting body 10B, wherein the light is generated from the LED light emitting body 10B.

In a specific embodiment, the electrode connection heat conducting-dissipating portion 30B comprises an inner copper layer and an external silver layer, wherein the external silver layer encloses the inner copper layer and the outer surface of the silver layer is a mirror surface.

The light reflection material is defined by the external silver layer and the inner copper layer.

When the electrode connection heat conducting-dissipating portion 30B is provided to surround multiple LED light emitting bodies 10B, a plurality of insulating plates are outwardly extended from the electrode connection heat conducting-dissipating portion 30B respectively and the insulating plates are spacedly provided between every two neighboring LED light emitting bodies 10B, wherein the insulating plates are capable of insulating different lights from the neighboring LED light emitting bodies 10B to prevent the different lights being mixed. In a specific embodiment, the signal power transmission heat-dissipation portion 40B comprises multiple signal power transmission heat-dissipation wires 41B, which are provided to surround the electrode connection heat conducting-dissipating portion 30B, as required.

In a specific embodiment, the signal power transmission heat-dissipation wires 41B are connected to a power supply and signal control module. Hence, the signal power transmission heat-dissipation wires 41B can be used for transmitting the electric current, the electric control signals and the heat-dissipation.

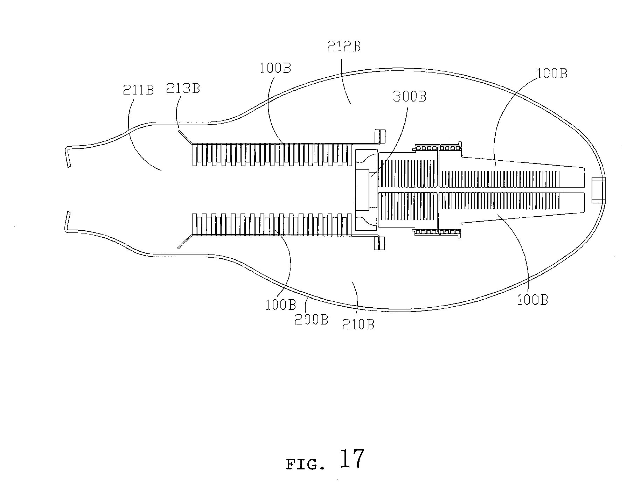

As shown in Figs.17 to 22, the LED light emitting body 10B and the heat dissipating conductor 20B define an LED light-emitting and heat-dissipating body 100B, wherein a sealing and transparent shade 200B having an inner surface is provided and the inner surface of the sealing and transparent shade 200B define an inner sealing cavity 210B and a plurality of LED light-emitting and heat-dissipating bodies 100B are arranged within the inner sealing cavity 210B, wherein the inner sealing cavity 210B is filled with dissipating gas, preferably, helium gas, wherein an airflow average-temperature equipment 300B is disposed within the inner sealing cavity 210B.

Under operating condition, the LED light emitting body 10B is energized to emit light and the heat generated by the LED light emitting body 10B is dissipated into the dissipating gas by the heat dissipating conductor 20B, and at the same time, the airflow average-temperature equipment 300B drives the dissipating gas to circulate within the inner sealing cavity 210B so as to make the dissipating gas at the different positions of the inner sealing cavity 210B have a consistent temperature that the dissipating gas can outwardly dissipate the heat by the sealing and transparent shade 200B lastly so as to enable the heat-dissipation structure for the LED lamp of the present invention to achieve an efficient and stable heat-dissipation effect.

In a specific embodiment, the sealing and transparent shade 200B is made of glass material, and the airflow average-temperature equipment 300B can be a fan.

In a specific embodiment, multiple LED light-emitting and heat-dissipating bodies 100B are arranged to define a tubular structure provided within the inner sealing cavity 210B so as to define a tubular LED light-emitting and heat-dissipating body unit.

The airflow average-temperature equipment 300B is provided at an end of the tubular LED light-emitting and heat-dissipating body unit.

The airflow average-temperature equipment 300B drives the dissipating gas to move from the exterior of the tubular LED light-emitting and heat-dissipating body unit into the tubular LED light-emitting and heat-dissipating body unit through an end thereof, and then flow away from the tubular LED light-emitting and heat-dissipating body unit through another end thereof and remove the heat, and that circle repeats.

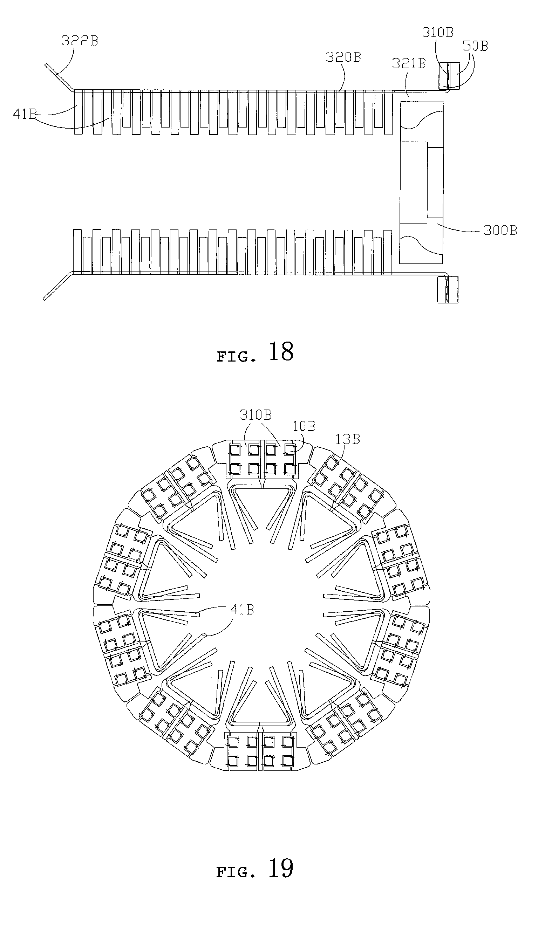

The LED light-emitting and heat-dissipating bodies 100B can be arranged to define the tubular LED light-emitting and heat-dissipating body unit in various different ways, and several exemplary embodiments are described as follows:
The electrode connection heat conducting-dissipating portion 30B comprises a wiring board 310B and an elongated board 320B, wherein the wiring board 310B is connected with a terminal end of the elongated board 320B, wherein the LED light emitting body 10B is connected with the wiring board 310B by the positive conductor and the negative conductor 13B, according to a first embodiment of the third technical solution of the present invention, as shown in Figs.18 to 19.

The signal power transmission heat-dissipation wires 41B of the signal power transmission heat-dissipation portion 40B are orderly connected with two sides of an elongated board 320B.

Each of the signal power transmission heat-dissipation wires 41B connected with the two sides of the elongated board 320B rolls from one side of the elongated board 320B to another side thereof to make the heat dissipating conductor 20B have a door-shaped cross section.

When the LED light-emitting and heat-dissipating bodies 100B are arranged to define the tubular LED light-emitting and heat-dissipating body unit, each of the signal power transmission heat-dissipation wires 41B is provided an inner tubular chamber of the tubular LED light-emitting and heat-dissipating body unit.

A terminal end of the tubular LED light-emitting and heat-dissipating body unit and the elongated board 320B can define a mounting chamber 321B, wherein the airflow average-temperature equipment 300B is provided in the mounting chamber 321B.

In a specific embodiment, the wiring board 310B is inclinedly connected with the elongated board 320B to define a connecting included angle, wherein the included angel is preferably a right-angle.

In a specific embodiment, a warping panel 322B is provided and connected with a terminal end of the elongated board 320B, wherein the warping panel 322B is inclinedly connected with the elongated board 320B.

Multiple warping panels 322B are arranged to define a circular insulating panel.

The circular insulating panel divides the inner sealing cavity 210B into an inlet cavity 211 B and a circulating cavity 212B, wherein the inlet cavity 211 B and the circulating cavity are communicated with each other by a long-narrow channel 213B. The long-narrow channel 213B is provided between an end surface of a periphery of the circular insulating panel and the inner surface of the sealing and transparent shade 200B.

The flow rate of the dissipating gas flowing through the long-narrow channel 213B can be reduced by the circular insulating panel to prolong the standing time of the dissipating gas staying in the circulating cavity 212B so as to make the dissipating gas be dissipated fully in the circulating cavity 212B, and then move into the inner tubular chamber of the tubular LED light-emitting and heat-dissipating body unit at a low temperature.

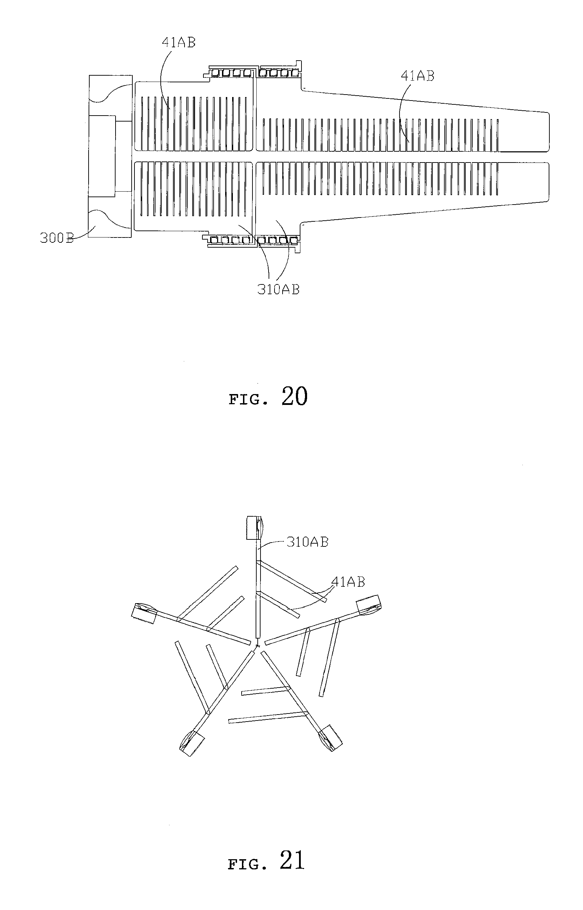

As shown in Fig.20 to 21, the electrode connection heat conducting-dissipating portion 30B comprises a wiring board 310AB, the LED light emitting body 10B is connected with the wiring board 310AB by the positive conductor and the negative conductor 13B, the signal power transmission heat-dissipation wires 41AB of the signal power transmission heat-dissipation portion 40B are orderly connected with one side of the wiring board 310AB.

The signal power transmission heat-dissipation wires 41AB connected with the side of the wiring board 310AB spacedly rolls from one side of the wiring board 310AB to another side thereof.

Multiple tubular LED light-emitting and heat-dissipating bodies 100B are radially and circularly arranged to define the tubular LED light-emitting and heat-dissipating body unit. The airflow average-temperature equipment 300B is provided a terminal end of the tubular LED light-emitting and heat-dissipating body unit.

In a specific embodiment, multiple tubular LED light-emitting and heat-dissipating body units are connected with each other end-to-head to improve the light emitting strength and heat-dissipation effect thereof.

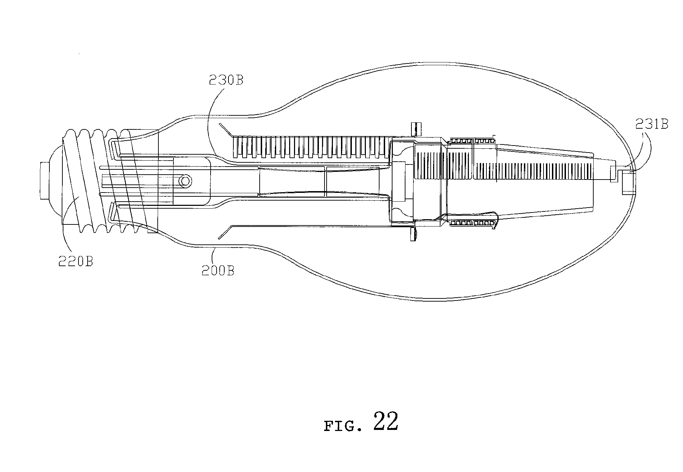

As shown in Fig.22, in addition, in another specific embodiment, the above first, and second embodiments can be combined to enhance the light emitting strength and heat-dissipation effect, for example, the airflow average-temperature equipment 300B can be provided between the tubular LED light-emitting and heat-dissipating body unit of the first embodiment and the tubular LED light-emitting and heat-dissipating body unit of the second embodiment.

As shown in Fig.22, in addition, in another specific embodiment, a remote fluorescence shade or rotation-prevent light shade to improve the optical effect thereof. The LED light emitting body 10B can employ various different colored light sources to provide different illumination effects by mixing lights.

In a specific embodiment, a terminal end of the sealing and transparent shade 200B is connected to a lamp head 220B, wherein the lamp head 220B can be disposed with a rectifier electric source.

A glass frame tube 230B is further inserted in the inner sealing cavity 210B of the sealing and transparent shade 200B, wherein the glass frame tube 230B is connected between the glass frame tube 230B and the lamp head 220B to avoid the heat generated from the lamp head 220B being transferred to the sealing and transparent shade 200B, wherein the electric components, for example, the RGB chip adaptor, are provided with the glass frame tube 230B.

An opposite terminal end of the sealing and transparent shade 200B is connected to a fixing head 231B, which is corresponding to the glass frame tube 230B, wherein the tubular LED light-emitting and heat-dissipating bodies 100B can be held in the inner sealing cavity 210B by utilizing the glass frame tube 230B and the fixing head 231B.

Lastly, it is worth mentioning that a magnetic field generator is provided in the sealing and transparent shade 200B of the present invention, wherein a magnetic field generated by the magnetic field generator can increase the radial heat-dissipation temperature of the components of the present invention to enhance the heat-dissipation effect.

## Claims

1. A heat-dissipation structure for an LED light source, which comprising at least one LED light emitting body and at least one heat dissipating conductor, wherein the LED light emitting body comprises a P-type semiconductor and a N-type semiconductor, wherein the P-type semiconductor and the N-type semiconductor define a PN junction allowing the voltage to be applied to two ends of the PN junction to make the PN junction form an energy level so as to enable electrons to move up from the energy level and produce photons, **characterized in that** the heat dissipating conductor is made of an exposed structure defining a large heat-dissipation surface, wherein the heat dissipating conductor comprises an electrode connection heat conducting and dissipating portion and a signal power transmission heat-dissipation portion, wherein the electrode connection heat conducting-dissipating portion is connected with the signal power transmission heat-dissipation portion to define the heat dissipating conductor, wherein each of the electrode connection heat conducting-dissipating portion and the signal power transmission heat-dissipation portion is respectively made of an exposed structure defining a large heat-dissipation surface, wherein the LED light emitting body comprises a positive conductor and a negative conductor connected respectively between the LED light emitting body and the electrode connection heat conducting-dissipating portion, wherein the electrode connection heat conducting-dissipating portion is used for transferring the electric current and the control signal from the signal power transmission heat-dissipation portion to the LED light emitting body by the positive and negative conductors, wherein the heat generated when the LED light emitting body is energized to emit light is conducted to the electrode connection heat conducting-dissipating portion by the positive and negative conductors and dissipated by the electrode connection heat conducting-dissipating portion, wherein the electrode connection heat conducting-dissipating portion is capable of transferring the heat to the signal power transmission heat-dissipation portion so as to enable the heat to be dissipated outwardly by the signal power transmission heat-dissipation portion.

2. The heat-dissipation structure, as recited in claim 1, **characterized in that** the signal power transmission heat-dissipation portion is naturally extended to define the electrode connection heat conducting and dissipating portion such that the electrode connection heat conducting and dissipating portion is defined from a partial portion of the signal power transmission heat-dissipation portion and has an external shape equal to the signal power transmission heat-dissipation portion.

3. The heat-dissipation structure, as recited in claim 1, **characterized in that** the LED light emitting body comprises an upper light emitting surface and a lower light emitting surface, wherein each of the upper light emitting surface and the lower light emitting surface of the LED light emitting body is covered by a light-heat transmitting crystal layer, wherein the light generated from the LED light emitting body outwardly ejects through the light-heat transmitting crystal layers, and at the same time, wherein the heat generated when the LED light emitting body is energized to emit light is transmitted to the light-heat transmitting crystal layers by the upper light emitting surface and the lower light emitting surface and dissipated by the light-heat transmitting crystal layers, wherein both of the LED light emitting body and the electrode connection heat conducting-dissipating portion are sandwiched between two light-heat transmitting crystal layers, wherein the heat transmitted by the upper light emitting surface and the lower light emitting surface to the light-heat transmitting crystal layers is dissipated by the light-heat transmitting crystal layers and simultaneously transmitted to the electrode connection heat conducting-dissipating portion such that the heat is dissipated by the electrode connection heat conducting-dissipating portion and the signal power transmission heat-dissipation portion.

4. The heat-dissipation structure, as recited in claim 3, **characterized in that** each of the LED light emitting body and the heat dissipating conductor has a plane structure, and the thickness of the LED light emitting body is equal to the electrode connection heat conducting-dissipating portion, wherein the LED light emitting body is sandwiched in an interval space between two light-heat transmitting crystal layers and the electrode connection heat conducting-dissipating portion is provided to surround the LED light emitting body, wherein the electrode connection heat conducting-dissipating portion is sandwiched between edge portions of the two light-heat transmitting crystal layers, wherein the signal power transmission heat-dissipation portion is radially connected with the electrode connection heat conducting-dissipating portion in a surrounding manner.

5. The heat-dissipation structure, as recited in claim 4, **characterized in that** the LED light emitting body, the electrode connection heat conducting-dissipating portion and the signal power transmission heat-dissipation portion are designed to have the same thickness.

6. The heat-dissipation structure, as recited in claim 1, 3 or 4, **characterized in that** the electrode connection heat conducting-dissipating portion is provided to surround simultaneously multiple LED light emitting bodies, and the positive and negative conductors of each of the LED light emitting bodies are connected with the electrode connection heat conducting-dissipating portion, wherein the LED light emitting bodies respectively emit different colored lights.

7. The heat-dissipation structure, as recited in claim 3 or 4, **characterized in that** the electrode connection heat conducting-dissipating portion is made of light proof and heat-electric conducting material to make the light generated by the LED light emitting body eject only through the light-heat transmitting crystal layers, wherein the electrode connection heat conducting-dissipating portion provides a light shading effect such that when the electrode connection heat conducting-dissipating portion surrounds the LED light emitting body, the electrode connection heat conducting-dissipating portion provide a light shading and limiting effect and the light generated by the LED light emitting body is limited in a predetermined region by the electrode connection heat conducting-dissipating portion to make the light eject only through the light-heat transmitting crystal layers so as to avoid the light being excessively scattered and defining a fuzzy region surrounding the LED light emitting body.

8. The heat-dissipation structure, as recited in claim 3 or 4, **characterized in that** the electrode connection heat conducting-dissipating portion is made of light reflection and heat-electric conducting material and the light ejected on the electrode connection heat conducting-dissipating portion is reflected by utilizing the light reflection performance of the electrode connection heat conducting-dissipating portion and rejects through the light-heat transmitting crystal layers.

9. The heat-dissipation structure, as recited in claim 8, **characterized in that** the electrode connection heat conducting-dissipating portion comprises an inner copper layer and an external silver layer, wherein the external silver layer encloses the inner copper layer and the outer surface of the silver layer is a mirror surface such that the light reflection and heat-electric conducting material is defined by the external silver layer and the inner copper layer.

10. The heat-dissipation structure, as recited in claim 6, **characterized in that** when the electrode connection heat conducting-dissipating portion is provided to surround the LED light emitting bodies, a plurality of insulating plates are provided and outwardly extended from the electrode connection heat conducting-dissipating portion respectively and the insulating plates are spacedly provided between every two neighboring LED light emitting bodies, wherein the insulating plates are capable of insulating different lights from the neighboring LED light emitting bodies to prevent the different lights being mixed.

11. The heat-dissipation structure, as recited in claim 6, **characterized in that** the electrode connection heat conducting-dissipating portion has a plurality of insulating outlets provided thereat, wherein the correct electric connection of the heat dissipating conductor is ensured by the insulating outlets to avoid the short circuit generated by the direct connection of the positive and the negative ends, wherein the insulating outlets are further used for separating the conductors having different electric control signals.

12. The heat-dissipation structure, as recited in claim 1, **characterized in that** the signal power transmission heat-dissipation portion comprises multiple signal power transmission heat-dissipation wires, wherein the signal power transmission heat-dissipation wires are provided to surround the electrode connection heat conducting-dissipating portion, wherein the signal power transmission heat-dissipation wires are used for transmitting the electric current, the electric control signals and the heat-dissipation.

13. The heat-dissipation structure, as recited in claim 3, **characterized in that** a plurality of optical protruding platforms are protruded from the light-heat transmitting crystal layer, wherein the optical protruding platforms are corresponding to the LED light emitting body, wherein the light-heat transmitting crystal layer further has a plurality of grooves provided at an inner surface thereof, wherein the electric connecting portions of the positive and negative conductors, which are connected with the electrode connection heat conducting-dissipating portion, are received in the grooves.

14. The heat-dissipation structure, as recited in claim 1, **characterized in that** two fixing dissipation plates are provided to sandwich the signal power transmission heat-dissipation portion at an upper side and a bottom side thereof.

15. The heat-dissipation structure, as recited in claim 12, **characterized in that** two fixing dissipation plates are provided to sandwich the signal power transmission heat-dissipation portion at an upper side and a bottom side thereof, wherein the fixing dissipation plates are made of transparent heat conducting-dissipating-insulating glass material, wherein the fixing dissipation plates assist in dissipating outwardly the heat thereof in a radiation manner.

16. A heat dissipating method for an LED light resource, comprising the steps of:
arranging the heat dissipating conductor to surround the LED light emitting body, wherein the LED light emitting body comprises a P-type semiconductor and a N-type semiconductor, wherein the P-type semiconductor and the N-type semiconductor define a PN junction,
wherein the heat dissipating conductor is made of an exposed structure defining a large heat-dissipation surface, wherein the heat dissipating conductor comprises an electrode connection heat conducting and dissipating portion and a signal power transmission heat-dissipation portion, wherein the electrode connection heat conducting-dissipating portion is connected with the signal power transmission heat-dissipation portion to define the heat dissipating conductor, wherein each of the electrode connection heat conducting-dissipating portion and the signal power transmission heat-dissipation portion is respectively made of an exposed structure defining a large heat-dissipation surface to improve greatly the heat dissipation and conduction effect of the electrode connection heat conducting and dissipating portion and the signal power transmission heat-dissipation portion; and
connecting respectively a positive conductor and a negative conductor of the LED light emitting body between the LED light emitting body and the electrode connection heat conducting-dissipating portion, wherein the electrode connection heat conducting-dissipating portion is used for transferring the electric current and the control signal from the signal power transmission heat-dissipation portion to the LED light emitting body by the positive and negative conductors, wherein the heat generated when the LED light emitting body is energized to emit light is conducted to the electrode connection heat conducting-dissipating portion by the positive and negative conductors and dissipated by the electrode connection heat conducting-dissipating portion, wherein the electrode connection heat conducting-dissipating portion is capable of transferring the heat to the signal power transmission heat-dissipation portion so as to enable the heat to be dissipated outwardly by the signal power transmission heat-dissipation portion.

17. The method, as recited in claim 16, **characterized in that** the LED light emitting body comprises an upper light emitting surface and a lower light emitting surface, wherein each of the upper light emitting surface and the lower light emitting surface of the LED light emitting body is covered by a light-heat transmitting crystal layer, wherein the light generated from the LED light emitting body outwardly ejects through the light-heat transmitting crystal layers, and at the same time, wherein the heat generated when the LED light emitting body is energized to emit light is transmitted to the light-heat transmitting crystal layers by the upper light emitting surface and the lower light emitting surface and dissipated by the light-heat transmitting crystal layers, wherein both of the LED light emitting body and the electrode connection heat conducting-dissipating portion are sandwiched between two light-heat transmitting crystal layers, wherein the heat transmitted by the upper light emitting surface and the lower light emitting surface to the light-heat transmitting crystal layers is dissipated by the light-heat transmitting crystal layers and simultaneously transmitted to the electrode connection heat conducting-dissipating portion such that the heat is dissipated by the electrode connection heat conducting-dissipating portion and the signal power transmission heat-dissipation portion.

18. The method, as recited in claim 17, **characterized in that** the LED light emitting body is sandwiched in an interval space between two light-heat transmitting crystal layers and the electrode connection heat conducting-dissipating portion is provided to surround the LED light emitting body, wherein the electrode connection heat conducting-dissipating portion is sandwiched between edge portions of the two light-heat transmitting crystal layers, wherein the signal power transmission heat-dissipation portion is radially connected with the electrode connection heat conducting-dissipating portion in a surrounding manner, wherein the electrode connection heat conducting-dissipating portion is made of light reflecting and heat-electric conducting material to make the light generated by the LED light emitting body eject only through the light-heat transmitting crystal layers, wherein the electrode connection heat conducting-dissipating portion provides a light shading effect such that when the electrode connection heat conducting-dissipating portion surrounds the LED light emitting body, the electrode connection heat conducting-dissipating portion provide a light shading and limiting effect and the light generated by the LED light emitting body is limited in a predetermined region by the electrode connection heat conducting-dissipating portion to make the light eject only through the light-heat transmitting crystal layers so as to avoid the light being excessively scattered and defining a fuzzy region surrounding the LED light emitting body, wherein the signal power transmission heat-dissipation portion comprises multiple signal power transmission heat-dissipation wires, wherein the signal power transmission heat-dissipation wires are provided to surround the electrode connection heat conducting-dissipating portion, wherein the signal power transmission heat-dissipation wires are used for transmitting the electric current, the electric control signals and the heat-dissipation.

19. A heat-dissipation structure for an LED light source, comprising at least one LED light emitting body and at least one heat dissipating conductor, wherein the LED light emitting body has an upper light emitting surface and a lower light emitting surface, wherein the heat dissipating conductor is made of an exposed structure having a large heat-dissipation surface, wherein the heat dissipating conductor comprises a conducting and transferring portion for holding the LED light emitting body and a signal power transmission heat-dissipation portion, wherein the conducting and transferring portion is fixed at the signal power transmission heat-dissipation portion, wherein the LED light emitting body is held at the conducting and transferring portion, wherein the conducting and transferring portion fixes the LED light emitting body at a position, which simultaneously enhances the heat transmission contact surface between the heat dissipating conductor and the LED light emitting body, wherein the conducting and transferring portion also transfers the electric current and the control signals from the signal power transmission heat-dissipation portion to the LED light emitting body, wherein the heat generated when the LED light emitting body is energized to emit light is directly conducted to the conducting and transferring portion and dissipated by the conducting and transferring portion, wherein the conducting and transferring portion simultaneously transfers the heat to the signal power transmission heat-dissipation portion and the heat is outwardly dissipated by the signal power transmission heat-dissipation portion.

20. The heat-dissipation structure, as recited in claim 19, **characterized in that** the LED light emitting body have a flip structure and is held between random two neighboring heat dissipating conductors, wherein the signal power transmission heat-dissipation portion has a top surface, a bottom surface and an external side, wherein the external side extended between the top surface and the bottom surface, wherein the conducting and transferring portion is extended and protruded from the external side of the signal power transmission heat-dissipation portion, wherein the conducting and transferring portions held respectively between random two neighboring signal power transmission heat-dissipation portions are correspond with each other, wherein each of the LED light emitting bodies is held between random two neighboring signal power transmission heat-dissipation portions, and the LED light emitting body is held at the conducting and transferring portions provided between random two neighboring signal power transmission heat-dissipation portions, wherein a p-junction and an n-junction of the LED light emitting body are respectively connected with the conducting and transferring portions.

21. The heat-dissipation structure, as recited in claim 20, **characterized in that**, a silver paste layer is provided between the LED light emitting body and the conducting and transferring portions.

22. The heat-dissipation structure, as recited in claim 19, **characterized in that** the LED light emitting body have a normal structure and is held between random two neighboring heat dissipating conductors, wherein the signal power transmission heat-dissipation portion has a top surface, a bottom surface and an external side, wherein the external side extended between the top surface and the bottom surface, wherein the conducting and transferring portion is extended and protruded from the external side of the signal power transmission heat-dissipation portion, wherein the conducting and transferring portions held respectively between random two neighboring signal power transmission heat-dissipation portions are correspond with each other, wherein each of the LED light emitting bodies is held between random two neighboring signal power transmission heat-dissipation portions, and the LED light emitting body is held at the conducting and transferring portions provided between random two neighboring signal power transmission heat-dissipation portions, wherein a p-junction and an n-junction of the LED light emitting body are respectively connected with the conducting and transferring portions by the heat dissipating conductors.

23. The heat-dissipation structure, as recited in claim 22, **characterized in that**, one heat-conducting adhesive layer is provided between the transparent heat-dissipation layer and the LED light emitting body, and another heat-conducting adhesive layer is provided between the LED light emitting body and the conducting and transferring portions.

24. The heat-dissipation structure, as recited in claim 19, **characterized in that** the LED light emitting body is held between random two neighboring heat dissipating conductors, wherein the signal power transmission heat-dissipation portion has a top surface, a bottom surface and an external side, wherein the external side extended between the top surface and the bottom surface, the conducting and transferring portion is extended and protruded from the external side of the signal power transmission heat-dissipation portion, wherein the p-junction and n-junction of the LED light emitting body are respectively connected with the signal power transmission heat-dissipation portion of one heat dissipating conductor by another heat dissipating conductor.

25. The heat-dissipation structure, as recited in claim 20, 21, 22, 23 or 24, **characterized in that**, two thermal radiation layers are respectively provided to sandwich the signal power transmission heat-dissipation portion at two sides thereof.

26. The heat-dissipation structure, as recited in claim 20, 21, 22, 23 or 24, **characterized in that**, two light-heat transmitting crystal layers are respectively provided to sandwich the LED light emitting body at two sides thereof.

27. The heat-dissipation structure, as recited in claim 19, **characterized in that** the heat dissipating conductor comprises a first conducting layer, a second conducting layer and an insulating layer, wherein the first conducting layer, the second conducting layer and the insulating layer are provided in a stacked manner, and the insulating layer is sandwiched between the first conducting layer and the second conducting layer, wherein the first conducting layer and the second conducting layer are electrically isolated from each other by the insulating layer, wherein the heat dissipating conductor is further sandwiched between two transparent heat-dissipation layers, wherein the transparent heat-dissipation layer comprises an electric conduction layer provided at a contact surface of the transparent heat-dissipation layer, wherein the contact surface contacts with the heat dissipating conductor, wherein every two neighboring heat dissipating conductors define a light resource chamber therebetween, and the LED light emitting body is sandwiched in the light resource chamber, wherein the p-junction and n-junction of the LED light emitting body are respectively connected with the corresponding first conducting layer and the corresponding second conducting layer by the electric conduction layers, wherein the first conducting layer and the second conducting layer define the signal power transmission heat-dissipation portion, and the two transparent heat-dissipation layers and the electric conduction layers thereof define the conducting and transferring portion.

28. The heat-dissipation structure, as recited in claim 27, **characterized in that** the surface of each of the first conducting layer and the second conducting layer is coated with a heat radiation layer, wherein two thermal radiation layers are respectively provided to sandwich the signal power transmission heat-dissipation portion at two sides thereof, wherein the signal power transmission heat-dissipation portions defined by the first conducting layer and the second conducting layer.

29. A heat-dissipation structure for an LED light source, comprising at least one LED light emitting body and at least one heat dissipating conductor, wherein the LED light emitting body has an upper light emitting surface and a lower light emitting surface, wherein the heat dissipating conductor is made of an exposed structure having a large heat-dissipation surface, wherein the heat dissipating conductor comprises an electrode connection heat conducting and dissipating portion and a signal power transmission heat-dissipation portion, wherein the electrode connection heat conducting-dissipating portion is connected with the signal power transmission heat-dissipation portion to define the heat dissipating conductor, wherein the LED light emitting body comprises a positive conductor and a negative conductor connected respectively between the LED light emitting body and the electrode connection heat conducting-dissipating portion, wherein the electrode connection heat conducting-dissipating portion is used for transferring the electric current and the control signal from the signal power transmission heat-dissipation portion to the LED light emitting body by the positive and negative conductors, wherein the heat generated when the LED light emitting body is energized to emit light is conducted to the electrode connection heat conducting-dissipating portion by the positive and negative conductors and dissipated by the electrode connection heat conducting-dissipating portion, wherein the electrode connection heat conducting-dissipating portion is capable of transferring the heat to the signal power transmission heat-dissipation portion so as to enable the heat to be dissipated outwardly by the signal power transmission heat-dissipation portion, wherein the signal power transmission heat-dissipation portion comprises multiple signal power transmission heat-dissipation wires, wherein the LED light emitting body and the heat dissipating conductor define an LED light-emitting and heat-dissipating body, wherein a sealing and transparent shade having an inner surface is provided and the inner surface of the sealing and transparent shade define an inner sealing cavity and a plurality of LED light-emitting and heat-dissipating bodies are arranged within the inner sealing cavity, wherein the inner sealing cavity is filled with dissipating gas, wherein an airflow average-temperature equipment is disposed within the inner sealing cavity, wherein the LED light emitting body is energized to emit light and the heat generated by the LED light emitting body is dissipated into the dissipating gas by the heat dissipating conductor, and at the same time, the airflow average-temperature equipment drives the dissipating gas to circulate within the inner sealing cavity so as to make the dissipating gas at the different positions of the inner sealing cavity have a consistent temperature that the dissipating gas can outwardly dissipate the heat by the sealing and transparent shade at last.

30. The heat-dissipation structure, as recited in claim 29, **characterized in that**, each of the upper light emitting surface and the lower light emitting surface of the LED light emitting body is respectively covered by a light-heat transmitting crystal layer, wherein the light generated from the LED light emitting body outwardly ejects through the light-heat transmitting crystal layers, and at the same time, the heat generated during the LED light emitting body is energized to emit light is transmitted to the light-heat transmitting crystal layers by the upper light emitting surface and the lower light emitting surface and dissipated by the light-heat transmitting crystal layers.

31. The heat-dissipation structure, as recited in claim 29, **characterized in that**, both of the LED light emitting body and the electrode connection heat conducting-dissipating portion are sandwiched between two light-heat transmitting crystal layers, wherein the heat transmitted by the upper light emitting surface and the lower light emitting surface to the light-heat transmitting crystal layers and dissipated by the light-heat transmitting crystal layers is simultaneously transmitted to the electrode connection heat conducting-dissipating portion and dissipated by the electrode connection heat conducting-dissipating portion and the signal power transmission heat-dissipation portion, wherein the LED light emitting body is sandwiched in an interval space between two light-heat transmitting crystal layers and the electrode connection heat conducting-dissipating portion is provided to surround the LED light emitting body, wherein the electrode connection heat conducting-dissipating portion is sandwiched between edge portions of the two light-heat transmitting crystal layers.

32. The heat-dissipation structure, as recited in claim 29, **characterized in that** the sealing and transparent shade is made of glass material, and the airflow average-temperature equipment is a fan.

33. The heat-dissipation structure, as recited in claim 29, **characterized in that** multiple LED light-emitting and heat-dissipating bodies are arranged to define a tubular structure provided within the inner sealing cavity so as to define a tubular LED light-emitting and heat-dissipating body unit, wherein the airflow average-temperature equipment drives the dissipating gas to move from the exterior of the tubular LED light-emitting and heat-dissipating body unit into the tubular LED light-emitting and heat-dissipating body unit through an end thereof, and then flow away from the tubular LED light-emitting and heat-dissipating body unit through another end thereof and remove the heat, and that circle repeats.

34. The heat-dissipation structure, as recited in claim 33, **characterized in that**, the electrode connection heat conducting-dissipating portion comprises a wiring board and an elongated board, wherein the wiring board is connected with a terminal end of the elongated board, wherein the LED light emitting body is connected with the wiring board by the positive conductor and the negative conductor, wherein the signal power transmission heat-dissipation wires of the signal power transmission heat-dissipation portion are orderly connected with two sides of an elongated board, wherein each of the signal power transmission heat-dissipation wires connected with the two sides of the elongated board rolls from one side of the elongated board to another side thereof, wherein when the LED light-emitting and heat-dissipating bodies are arranged to define the tubular LED light-emitting and heat-dissipating body unit, each of the signal power transmission heat-dissipation wires is provided an inner tubular chamber of the tubular LED light-emitting and heat-dissipating body unit, wherein the terminal ends of the tubular LED light-emitting and heat-dissipating body units define a mounting chamber by multiple elongated boards, wherein the airflow average-temperature equipment is provided in the mounting chamber, wherein the wiring board is inclinedly connected with the elongated board to define a connecting included angle.

35. The heat-dissipation structure, as recited in claim 34, **characterized in that**, a warping panel is provided and connected with a terminal end of the elongated board, wherein the warping panel is inclinedly connected with the elongated board, wherein multiple warping panels are arranged to define a circular insulating panel, wherein the circular insulating panel divides the inner sealing cavity into an inlet cavity and a circulating cavity, wherein the inlet cavity and the circulating cavity are communicated with each other by a long-narrow channel, wherein the long-narrow channel is provided between an end surface of a periphery of the circular insulating panel and the inner surface of the sealing and transparent shade, wherein the flow rate of the dissipating gas flowing through the long-narrow channel is reduced by the circular insulating panel to prolong the standing time of the dissipating gas staying in the circulating cavity so as to make the dissipating gas be dissipated fully in the circulating cavity, and then move into the inner tubular chamber of the tubular LED light-emitting and heat-dissipating body unit at a low temperature.

36. The heat-dissipation structure, as recited in claim 33, **characterized in that**, the electrode connection heat conducting-dissipating portion comprises a wiring board, wherein the LED light emitting body is connected with the wiring board by the positive conductor and the negative conductor, wherein the signal power transmission heat-dissipation wires of the signal power transmission heat-dissipation portion are orderly connected with one side of the wiring board, wherein the signal power transmission heat-dissipation wires connected with the side of the wiring board spacedly rolls from one side of the wiring board to another side thereof, wherein multiple tubular LED light-emitting and heat-dissipating bodies are radially and circularly arranged to define the tubular LED light-emitting and heat-dissipating body unit, wherein the airflow average-temperature equipment is provided a terminal end of the tubular LED light-emitting and heat-dissipating body unit.

37. The heat-dissipation structure, as recited in claim 29, 30, 31, 32, 33, 34, 35 or 36, **characterized in that**, a terminal end of the sealing and transparent shade is connected to a lamp head, wherein a glass frame tube is further inserted in the inner sealing cavity of the sealing and transparent shade, wherein the glass frame tube is connected between the glass frame tube and the lamp head to avoid the heat generated from the lamp head being transferred to the sealing and transparent shade, wherein an opposite terminal end of the sealing and transparent shade is connected to a fixing head, which is corresponding to the glass frame tube, wherein the tubular LED light-emitting and heat-dissipating bodies are held in the inner sealing cavity by utilizing the glass frame tube and the fixing head.

38. The heat-dissipation structure, as recited in claim 29, 30, 31, 32, 33, 34, 35 or 36, **characterized in that**, a magnetic field generator is provided in the sealing and transparent shade, wherein a magnetic field generated by the magnetic field generator increases the radial heat-dissipation temperature of the heat-dissipation structure.
